# EUROPEAN PATENT APPLICATION

(11) **EP 4 478 238 A1**
(43) Date of publication of application: **18.12.2024**
(21) Application number: 23188238.2
(22) Date of filing: 27.07.2023
(51) Int. Cl.: G06F 30/20, G06N 20/00, G06Q 10/0639

(54) **FRAMEWORK FOR EVALUATION OF COMPUTER-BASED MODELS**

(30) Priority: 14.06.2023 US 202363508211 P; 10.07.2023 US 202318349738
(71) Applicant: Palantir Technologies Inc., Denver, CO 80202 (US)
(72) Inventor: Jagasia, Arnav, Denver, 80202 (US); Arora, Megha, Denver, 80202 (US); Scannell, Sophie, Denver, 80202 (US); Su, Emily, Denver, 80202 (US); Nayan, Meghan, Denver, 80202 (US); McNeal, Angela, Denver, 80202 (US); Lisuk, David, Denver, 80202 (US); Inoue, Jim, Denver, 80202 (US); Ngai, Justin, Denver, 80202 (US)
(74) Representative: Jolliffe, Jack Louis

(57) **Abstract**

Computer-implemented systems and methods are disclosed , including for evaluation of computer-based models in a management framework. A computer-implemented method may include, for example, receiving one or more inputs including requesting to add an evaluation configuration to a defined modeling objective, specifying at least a first evaluation data set for the evaluation configuration, specifying at least a first evaluation library for the evaluation configuration, and specifying at least a first subset definition for the evaluation configuration. A computer-implemented method may in response to the one or more user inputs include: creating, storing, and/or updating the evaluation configuration. A computer-implemented method may include evaluating, based on the evaluation configuration, the one or more models associated with the defined modeling objective.

## Description

### CROSS-REFERENCE TO RELATED APPLICATIONS

This application claims benefit of U.S. Provisional Patent Application No. 63/508,211, filed June 14, 2023, and titled "FRAMEWORK FOR EVALUATION OF COMPUTER-BASED MODELS." The entire disclosure of each of the above items is hereby made part of this specification as if set forth fully herein and incorporated by reference for all purposes, for all that it contains.

Any and all applications for which a foreign or domestic priority claim is identified in the Application Data Sheet as filed with the present application are hereby incorporated by reference under 37 CFR 1.57 for all purposes and for all that they contain.

### TECHNICAL FIELD

The present disclosure relates to systems and techniques for data integration, analysis, and visualization. More specifically, the present disclosure relates to systems and a framework for integration, management, and evaluation of computer-based models in a model management system.

### BACKGROUND

The approaches described in this section are approaches that could be pursued, but not necessarily approaches that have been previously conceived or pursued. Therefore, unless otherwise indicated, it should not be assumed that any of the approaches described in this section qualify as prior art merely by virtue of their inclusion in this section.

Computers can be programmed to perform calculations and operations utilizing one or more computer-based models. Various techniques have been developed to minimize the effort required by a human user in in adapting and reprogramming the computer for utilizing such computer-based models.

### SUMMARY

The systems, methods, and devices described herein each have several aspects, no single one of which is solely responsible for its desirable attributes. Without limiting the scope of this disclosure, several non-limiting features will now be described briefly.

Computer-based models (generally referred to herein as "models") can be useful tools in processing and using data. An individual or entity (generally referred to herein as "organizations") may use models to inform important decisions. However, a model may lack accuracy or precision, limiting the usefulness of the model. Thus, model evaluations can be useful in informing model use. Existing techniques for model evaluation can lack user accessibility. For example, model evaluation may require coding and other specialized knowledge to set up and use. Further, existing techniques for model evaluation can lack the ability to easily analyze how a model performs on various subsets of the inputted data. Additionally, a technique for evaluating one model might be useful in evaluating additional models, but the technique might be inapplicable to the additional models due to the format of the data involved with each model. The resources needed to create, use, adapt, and manage model evaluations can cause difficulty for organizations when utilizing model evaluation.

The present disclosure includes a system and/or framework for model evaluation and management of evaluation configurations (generally referred to herein as "the model management system" or "the system"). The present disclosure further includes various processes, functionality, and interactive graphical user interfaces related to the system. The system can utilize evaluation configurations that can be applied to multiple related models to enable automatic and/or consistent model evaluations. According to various implementations, the system (and related processes, functionality, and interactive graphical user interfaces), can advantageously provide for management of multiple (including large numbers of) evaluation configurations in a consistent and centralized way, where each of the evaluation configurations can be applied to groups of related models.

The system can include one or more modeling objectives (also referred to herein as a "defined modeling objectives"). A defined modeling objective can be representative of any task or objective, such as a processing, prediction, estimation, and/or analysis task (and/or the like). A modeling objective can be associated with one or more models configured to execute a portion of, or the entire, task or objective associated with the modeling objective. For example, a modeling objective can be used to determine housing prices in the United States. Inputs to such a modeling objective can include real world properties such as house location, number of rooms, square footage, and location, while the modeling objective output is an estimated house price.

The system can associate an evaluation configuration with a defined modeling objective. The system may operate to evaluate multiple models based on the evaluation configuration associated with a defined modeling objective. The system may allow for the selection of data (referred to herein as the "evaluation data set") that is to be used in an evaluation configuration to evaluate models associated with the defined modeling objective. The evaluation data set can include model input data, model output data, expected values, and/or other data used in model evaluation. The system may allow for evaluation configurations to be implemented using stored evaluation metrics. The evaluation metrics can include the computer code and functions used to process and evaluate the models. The evaluation metrics can be compiled into an evaluation library and used to execute the evaluation configuration. The selection of an evaluation library can be tailored to the needs of the defined modeling objective and to the evaluation data set used in the evaluation configuration. For example, the defined modeling objective or the evaluation data set may require specific evaluation metrics.

The system may allow for a definition of subsets of the evaluation data sets used in the evaluation configuration. For example, the system may allow for a selection of data buckets, data ranges, a number of subsets, and/or the like, to partition an evaluation data set. The system may evaluate the models across the subsets.

The system can update the evaluation configuration. For example, the system may receive a new or updated model associated with a modeling objective (e.g., the new or updated model may be submitted to or received by the system). The system can automatically evaluate the new or updated model using the evaluation data sets and evaluation libraries associated with the evaluation configuration.

In various implementations, an evaluation configuration can include a plurality of evaluation data sets, a plurality of evaluation libraries, a plurality of subset definitions (e.g., that may each identify respective subsets of evaluation data), and/or the like.

The system can include evaluation libraries in the evaluation configuration. The evaluation libraries can define the evaluation metrics used in the evaluation configuration to evaluate the models. The evaluation libraries can be selectable. For example, the system can receive selections of evaluation libraries through interactive graphical user interfaces. The system can provide a listing of selectable evaluation libraries to the interactive graphical user interface. The listing of selectable evaluation libraries can be searchable. For example, the listing of selectable evaluation libraries may be searched using an interactive graphical interface. The system can determine the listing of selectable evaluation libraries based on one or more evaluation library definitions. The evaluation library definitions can include descriptions of the evaluation libraries, identifications of user definable data fields, and/or specifications for determining related evaluation metrics. The descriptions of the evaluation libraries can be determined based on parsable descriptions of the library definitions.

The system can identify and/or define data within an evaluation data set based on a specifying of an evaluation library. For example, the system may receive a specification of an evaluation library and identify and/or define expected values and model outputs in an evaluation data set. A specification of an evaluation library can be received through an interactive graphical interface, such as through the listing of selectable evaluation libraries.

An evaluation library can be preintegrated, preloaded, or predefined in the system (referred to herein as a "core evaluation library"). An evaluation library can also be user created (referred to herein as a "user-defined evaluation library"). For example, the system can receive user definitions of one or more evaluation library definitions, and the evaluation library definitions can define the core evaluation libraries and/or the user-defined evaluation libraries. The user definitions and/or the evaluation library definitions can be computer-readable code. The system can include user-defined evaluation libraries and core evaluation libraries in the listing of selectable evaluation libraries.

The system may regulate access to one or more evaluation libraries based on user permissions associated with a user. For example, a user may have organization credentials, personal identifiers, subscriptions, and/or other indicators associated with the user that can restrict and/or grant access to one or more evaluation libraries. The system may only list evaluation libraries in the listing of selectable evaluation libraries that correspond to the user permissions.

The system may operate to evaluate multiple models based on an evaluation configuration associated with a defined modeling objective. To evaluate the models, the system may execute the models using an evaluation data set. The system may determine, for each of the models, overall values for each evaluation metric included in the evaluation library. For example, for each of the models, the system may use the evaluation library, the evaluation data set, and the outputs of the models to determine an overall value for each evaluation metric. The evaluation data set may include expected values. Expected values can include values associated with the actual outcomes the system is using the models to predict. For example, for a model that receives inputs and determines an estimated housing price, the system may have expected values that include housing prices of sold houses that correspond to the received inputs of the model. Determining overall values for evaluation metrics for models may include analyzing the output of the models with expected values included in the evaluation data set. The system may determine for each defined subset of the evaluation data set, subset values for each of the evaluation metrics.

When an evaluation configuration includes a plurality of evaluation data sets, a plurality of evaluation libraries, and/or a plurality of subset definitions, the system can determine values for some or all of each of the combinations of, for example, subsets of evaluation data. Thus, for example, various subsets can be compared across multiple dimensions of data field values, and/or the like.

According to various implementations, the system can incorporate and/or communicate with one or more LLMs to perform various functions. Such communications may include, for example, a context associated with an aspect or analysis being performed by the system, a user-generated prompt, an engineered prompt, prompt and response examples, example or actual data, and/or the like. For example, the system may employ an LLM, via providing an input to, and receiving an output from, the LLM. The output from the LLM may be parsed and/or a format of the output may be updated to be usable for various aspects of the system.

The system may employ an LLM to, for example, determine a modeling objective (e.g., based on one or more models and/or other information), identify additional models that may be related to the modeling objective, determine or generate an evaluation configuration, determine or generate an evaluation data set, determine or generate an evaluation library, determine or generate or evaluate subset definitions and/or subsets, determine or generate one or more evaluation metrics, evaluate the results of model evaluations (e.g., evaluate determined evaluation metric values), and/or the like.

The system can include interactive graphical user interfaces that enable adding and configuring evaluation configurations. For example, the user interfaces can receive one or more inputs from the interactive graphical user interface and select modeling objectives, specify evaluation data sets, specify evaluation libraries, and specify subsets. The system can output the results of an evaluation configuration to the user interface. For example, the system can output the results of an evaluation configuration for each of the models associated with the modeling objective in a consistent format. The outputs can include, for example, graphical visualizations such as charts, tables, lists, and/or the like. The visualizations may be user defined, and be specified by the evaluation library (and/or other aspects of the system). The system can output the results of an evaluation configuration on a model for each of the defined subsets in a consistent format. Additionally, when an evaluation configuration includes a plurality of evaluation data sets, a plurality of evaluation libraries, and/or a plurality of subset definitions, the system can output and display various for some or all of each of the combinations of, for example, subsets of evaluation data. Thus, for example, various subsets can be displayed and compared across multiple dimensions of data field values, and/or the like.

The system can identify when errors occur while implementation of an evaluation configuration. Errors may occur when the data is mismatched between the evaluation data set and the evaluation library. For example, an evaluation metric associated with an evaluation library may require data of a particular format. If the format of the corresponding field in the evaluation data set does not match the particular format, the system may identify an error in the implementation. The system can output an indication of the error to one or more interactive graphical interfaces.

According to various implementations, large amounts of data are automatically and dynamically calculated interactively in response to user inputs, and the calculated data is efficiently and compactly presented to a user by the system. Thus, in some implementations, the user interfaces described herein are more efficient as compared to previous user interfaces in which data is not dynamically updated and compactly and efficiently presented to the user in response to interactive inputs.

Further, as described herein, the system may be configured and/or designed to generate user interface data useable for rendering the various interactive user interfaces described. The user interface data may be used by the system, and/or another computer system, device, and/or software program (for example, a browser program), to render the interactive user interfaces. The interactive user interfaces may be displayed on, for example, electronic displays (including, for example, touch-enabled displays).

Additionally, it has been noted that design of computer user interfaces that are useable and easily learned by humans is a non-trivial problem for software developers. The present disclosure describes various implementations of interactive and dynamic user interfaces that are the result of significant development. This non-trivial development has resulted in the user interfaces described herein which may provide significant cognitive and ergonomic efficiencies and advantages over previous systems. The interactive and dynamic user interfaces include improved human-computer interactions that may provide reduced mental workloads, improved decision-making, reduced work stress, and/or the like, for a user. For example, user interaction with the interactive user interface via the inputs described herein may provide an optimized display of, and interaction with, models and model-related data, and may enable a user to more quickly and accurately access, navigate, assess, and digest the model-related data than previous systems.

Further, the interactive and dynamic user interfaces described herein are enabled by innovations in efficient interactions between the user interfaces and underlying systems and components. For example, disclosed herein are improved methods of receiving user inputs (including methods of interacting with, managing, and evaluating models), translation and delivery of those inputs to various system components, automatic and dynamic execution of complex processes in response to the input delivery, automatic interaction among various components and processes of the system, and automatic and dynamic updating of the user interfaces (to, for example, display the model-related and evaluation-related data). The interactions and presentation of data via the interactive user interfaces described herein may accordingly provide cognitive and ergonomic efficiencies, among various additional technical advantages over previous systems.

Thus, various implementations of the present disclosure can provide improvements to various technologies and technological fields, and practical applications of various technological features and advancements. For example, as described above, existing computer-based model evaluation technology is limited in various ways, and various implementations of the disclosure provide significant technical improvements over such technology. Additionally, various implementations of the present disclosure are inextricably tied to computer technology. In particular, various implementations rely on operation of technical computer systems and electronic data stores, automatic processing of electronic data, and the like. Such features and others (e.g., processing and analysis of large amounts of electronic data, management of data migrations and integrations, and/or the like) are intimately tied to, and enabled by, computer technology, and would not exist except for computer technology. For example, the evaluation of computer-based models described below in reference to various implementations cannot reasonably be performed by humans alone, without the computer technology upon which they are implemented. Further, the implementation of the various implementations of the present disclosure via computer technology enables many of the advantages described herein, including more efficient management of various types of electronic data (including computer-based models and electronic data used in the evaluation of computer-based models).

Various combinations of the above and below recited features, embodiments, implementations, and aspects are also disclosed and contemplated by the present disclosure.

Additional implementations of the disclosure are described below in reference to the appended claims, which may serve as an additional summary of the disclosure.

In various implementations, systems and/or computer systems are disclosed that comprise a computer-readable storage medium having program instructions embodied therewith, and one or more processors configured to execute the program instructions to cause the systems and/or computer systems to perform operations comprising one or more aspects of the above- and/or below-described implementations (including one or more aspects of the appended claims).

In various implementations, computer-implemented methods are disclosed in which, by one or more processors executing program instructions, one or more aspects of the above- and/or below-described implementations (including one or more aspects of the appended claims) are implemented and/or performed.

In various implementations, computer program products comprising a computer-readable storage medium are disclosed, wherein the computer-readable storage medium has program instructions embodied therewith, the program instructions executable by one or more processors to cause the one or more processors to perform operations comprising one or more aspects of the above- and/or below-described implementations (including one or more aspects of the appended claims).

### BRIEF DESCRIPTION OF THE DRAWINGS

The following drawings and the associated descriptions are provided to illustrate implementations of the present disclosure and do not limit the scope of the claims. Aspects and many of the attendant advantages of this disclosure will become more readily appreciated as the same become better understood by reference to the following detailed description, when taken in conjunction with the accompanying drawings, wherein:
FIG. 1 is a schematic block diagram of an example model management system in an example computing environment;
FIG. 2 is a flow chart depicting an example process for selecting and configuring an evaluation configuration as part of a model management system;
FIG. 3 is a flow chart depicting an example process for evaluating one or more models associated with a defined modeling objective based on an evaluation configuration as part of a model management system;
FIG. 4 is a flow chart depicting an example process for specifying one or more evaluation libraries for an evaluation configuration as part of a model management system;
FIG. 5 is a flow chart depicting an example process for determining an evaluation library definition for an evaluation configuration as part of a model management system;
FIG. 6 is a flow chart depicting an example process for specifying one or more subset definitions for the evaluation configuration as part of a model management system;
FIG. 7 is a flow chart depicting an example process for automatically evaluating new and/or updated models in an evaluation configuration as part of a model management system;
FIGS. 8, 9A-9C, and 10A-10B are illustrations of example user interfaces of a model management system; and
FIG. 11 is a block diagram of an example computer system consistent with various implementations of the present disclosure.

### DETAILED DESCRIPTION

Although certain preferred implementations, embodiments, and examples are disclosed below, the inventive subject matter extends beyond the specifically disclosed implementations to other alternative implementations and/or uses and to modifications and equivalents thereof. Thus, the scope of the claims appended hereto is not limited by any of the particular implementations described below. For example, in any method or process disclosed herein, the acts or operations of the method or process may be performed in any suitable sequence and are not necessarily limited to any particular disclosed sequence. Various operations may be described as multiple discrete operations in turn, in a manner that may be helpful in understanding certain implementations; however, the order of description should not be construed to imply that these operations are order dependent. Additionally, the structures, systems, and/or devices described herein may be embodied as integrated components or as separate components. For purposes of comparing various implementations, certain aspects and advantages of these implementations are described. Not necessarily all such aspects or advantages are achieved by any particular implementation. Thus, for example, various implementations may be carried out in a manner that achieves or optimizes one advantage or group of advantages as taught herein without necessarily achieving other aspects or advantages as may also be taught or suggested herein.

### I. Overview

As noted above, computer-based models (generally referred to herein as "models") can be useful tools in processing and using data. An individual or entity (generally referred to herein as "organizations") may use models to inform important decisions. However, a model may lack accuracy or precision, limiting the usefulness of the model. Thus, model evaluations can be useful in informing model use. Existing techniques for model evaluation can lack user accessibility. For example, model evaluation may require coding and other specialized knowledge to set up and use. Further, existing techniques for model evaluation can lack the ability to easily analyze how a model performs on various subsets of the inputted data. Additionally, a technique for evaluating one model might be useful in evaluating additional models, but the technique might be inapplicable to the additional models due to the format of the data involved with each model. The resources needed to create, use, adapt, and manage model evaluations can cause difficulty for organizations when utilizing model evaluation.

As also noted above, the present disclosure includes a system and/or framework for model evaluation and management of evaluation configurations (generally referred to herein as "the model management system" or "the system"). The present disclosure further includes various processes, functionality, and interactive graphical user interfaces related to the system. The system can utilize evaluation configurations that can be applied to multiple related models to enable automatic and/or consistent model evaluations. According to various implementations, the system (and related processes, functionality, and interactive graphical user interfaces), can advantageously provide for management of multiple (including large numbers of) evaluation configurations in a consistent and centralized way, where each of the evaluation configurations can be applied to groups of related models.

To facilitate an understanding of the systems and methods discussed herein, several terms are described below. These terms, as well as other terms used herein, should be construed to include the provided descriptions, the ordinary and customary meanings of the terms, and/or any other implied meaning for the respective terms, wherein such construction is consistent with context of the term. Thus, the descriptions below do not limit the meaning of these terms, but only provide example descriptions.

The term "model," as used in the present disclosure, can include any computer-based models of any type and of any level of complexity, such as any type of sequential, functional, or concurrent model. Models can further include various types of computational models, such as, for example, artificial neural networks ("NN"), language models (e.g., large language models ("LLMs")), artificial intelligence ("AI") models, machine learning ("MI,") models, multimodal models (e.g., models or combinations of models that can accept inputs of multiple modalities, such as images and text), and/or the like.

A Language Model is any algorithm, rule, model, and/or other programmatic instructions that can predict the probability of a sequence of words. A language model may, given a starting text string (e.g., one or more words), predict the next word in the sequence. A language model may calculate the probability of different word combinations based on the patterns learned during training (based on a set of text data from books, articles, websites, audio files, etc.). A language model may generate many combinations of one or more next words (and/or sentences) that are coherent and contextually relevant. Thus, a language model can be an advanced artificial intelligence algorithm that has been trained to understand, generate, and manipulate language. A language model can be useful for natural language processing, including receiving natural language prompts and providing natural language responses based on the text on which the model is trained. A language model may include an n-gram, exponential, positional, neural network, and/or other type of model.

A Large Language Model ("LLM") is any type of language model that has been trained on a larger data set and has a larger number of training parameters compared to a regular language model. An LLM can understand more intricate patterns and generate text that is more coherent and contextually relevant due to its extensive training. Thus, an LLM may perform well on a wide range of topics and tasks. An LLM may comprise a NN trained using self-supervised learning. An LLM may be of any type, including a Question Answer ("QA") LLM that may be optimized for generating answers from a context, a multimodel LLM/model, and/or the like. An LLM (and/or other models of the present disclosure), may include, for example, attention-based and/or transformer architecture or functionality, such as described in, for example: Ashish Vaswani, et al., "Attention is all you need," Advances in Neural Information Processing Systems, pp. 5998-6008 (2017); and U.S. Patent Nos. 10,452,978 and 11,556,786.

While certain aspects and implementations are discussed herein with reference to use of a language model, LLM, and/or AI, those aspects and implementations may be performed by any other language model, LLM, AI model, generative AI model, generative model, ML model, NN, multimodel model, and/or other algorithmic processes. Similarly, while certain aspects and implementations are discussed herein with reference to use of a ML model, those aspects and implementations may be performed by any other AI model, generative AI model, generative model, NN, multimodel model, and/or other algorithmic processes.

In various implementations, the LLMs and/or other models (including ML models) of the present disclosure may be locally hosted, cloud managed, accessed via one or more Application Programming Interfaces ("APIs"), and/or any combination of the foregoing and/or the like. Additionally, in various implementations, the LLMs and/or other models (including ML models) of the present disclosure may be implemented in or by electronic hardware such application-specific processors (e.g., application-specific integrated circuits ("ASICs")), programmable processors (e.g., field programmable gate arrays ("FPGAs")), application-specific circuitry, and/or the like. Data that may be queried using the systems and methods of the present disclosure may include any type of electronic data, such as text, files, documents, books, manuals, emails, images, audio, video, databases, metadata, positional data (e.g., geo-coordinates), geospatial data, sensor data, web pages, time series data, and/or any combination of the foregoing and/or the like. In various implementations, such data may comprise model inputs and/or outputs, model training data, modeled data, and/or the like.

Examples of models, language models, and/or LLMs that may be used in various implementations of the present disclosure include, for example, Bidirectional Encoder Representations from Transformers (BERT), LaMDA (Language Model for Dialogue Applications), PaLM (Pathways Language Model), PaLM 2 (Pathways Language Model 2), Generative Pre-trained Transformer 2 (GPT-2), Generative Pre-trained Transformer 3 (GPT-3), Generative Pre-trained Transformer 4 (GPT-4), LLaMA (Large Language Model Meta AI), and BigScience Large Open-science Open-access Multilingual Language Model (BLOOM).

A data store can be any computer-readable storage medium and/or device (or collection of data storage mediums and/or devices). Examples of data stores include, but are not limited to, optical disks (e.g., CD-ROM, DVD-ROM, and the like), magnetic disks (e.g., hard disks, floppy disks, and the like), memory circuits (e.g., solid state drives, random-access memory (RAM), and the like), and/or the like. Another example of a data store is a hosted storage environment that includes a collection of physical data storage devices that may be remotely accessible and may be rapidly provisioned as needed (commonly referred to as "cloud" storage).

A database can be any data structure (and/or combinations of multiple data structures) for storing and/or organizing data, including, but not limited to, relational databases (e.g., Oracle databases, PostgreSQL databases, MySQL databases and the like), non-relational databases (e.g., NoSQL databases, and the like), in-memory databases, spreadsheets, as comma separated values ("CSV") files, eXtensible markup language ("XML") files, TeXT ("TXT") files, flat files, spreadsheet files, and/or any other widely used or proprietary format for data storage. Databases are typically stored in one or more data stores. Accordingly, each database referred to herein (e.g., in the description herein and/or the figures of the present application) can be understood as being stored in one or more data stores. Additionally, although the present disclosure may show or describe data as being stored in combined or separate databases, in various embodiments such data may be combined and/or separated in any appropriate way into one or more databases, one or more tables of one or more databases, and/or the like.

A data item can be a data representation or container for information representing a specific thing in the world that have a number of definable properties. For example, a data item can represent an entity such as a physical object, a parcel of land or other real property, a market instrument, a policy or contract, or other noun. Each data item may be associated with a unique identifier that uniquely identifies the data item. The item's attributes (e.g. metadata about the object) may be represented in one or more properties. Attributes may include, for example, a geographic location associated with the item, a value associated with the item, a probability associated with the item, an event associated with the item, and so forth.

### Example Aspects Related to the Modeling Objective

The system can include one or more modeling objectives (also referred to herein as a "defined modeling objectives"). A defined modeling objective can be representative of any task or objective, such as a processing, prediction, estimation, and/or analysis task (and/or the like). A modeling objective can be associated with one or more models configured to execute a portion of, or the entire, task or objective associated with the modeling objective. For example, a modeling objective can be used to determine housing prices in the United States. Inputs to such a modeling objective can include real world properties such as house location, number of rooms, square footage, and location, while the modeling objective output is an estimated house price.

### Example Aspects Related to the Evaluation Configuration

The system can associate an evaluation configuration with a defined modeling objective. The system may operate to evaluate multiple models based on the evaluation configuration associated with a defined modeling objective. The system may allow for the selection of data (referred to herein as the "evaluation data set") that is to be used in an evaluation configuration to evaluate models associated with the defined modeling objective. The evaluation data set can include model input data, model output data, expected values, and/or other data used in model evaluation. The system may allow for evaluation configurations to be implemented using stored evaluation metrics. The evaluation metrics can include the computer code and functions used to process and evaluate the models. The evaluation metrics can be compiled into an evaluation library and used to execute the evaluation configuration. The selection of an evaluation library can be tailored to the needs of the defined modeling objective and to the evaluation data set used in the evaluation configuration. For example, the defined modeling objective or the evaluation data set may require specific evaluation metrics.

The system may allow for a definition of subsets of the evaluation data sets used in the evaluation configuration. For example, the system may allow for a selection of data buckets, data ranges, a number of subsets, and/or the like, to partition an evaluation data set. The system may evaluate the models across the subsets.

The system can update the evaluation configuration. For example, the system may receive a new or updated model associated with a modeling objective (e.g., the new or updated model may be submitted to or received by the system). The system can automatically evaluate the new or updated model using the evaluation data sets and evaluation libraries associated with the evaluation configuration.

In various implementations, an evaluation configuration can include a plurality of evaluation data sets, a plurality of evaluation libraries, a plurality of subset definitions (e.g., that may each identify respective subsets of evaluation data), and/or the like.

### Example Aspects Related to the Evaluation Library

The system can include evaluation libraries in the evaluation configuration. The evaluation libraries can define the evaluation metrics used in the evaluation configuration to evaluate the models. The evaluation libraries can be selectable. For example, the system can receive selections of evaluation libraries through interactive graphical user interfaces. The system can provide a listing of selectable evaluation libraries to the interactive graphical user interface. The listing of selectable evaluation libraries can be searchable. For example, the listing of selectable evaluation libraries may be searched using an interactive graphical interface. The system can determine the listing of selectable evaluation libraries based on one or more evaluation library definitions. The evaluation library definitions can include descriptions of the evaluation libraries, identifications of user definable data fields, and/or specifications for determining related evaluation metrics. The descriptions of the evaluation libraries can be determined based on parsable descriptions of the library definitions.

The system can identify and/or define data within an evaluation data set based on a specifying of an evaluation library. For example, the system may receive a specification of an evaluation library and identify and/or define expected values and model outputs in an evaluation data set. A specification of an evaluation library can be received through an interactive graphical interface, such as through the listing of selectable evaluation libraries.

An evaluation library can be preintegrated, preloaded, or predefined in the system (referred to herein as a "core evaluation library"). An evaluation library can also be user created (referred to herein as a "user-defined evaluation library"). For example, the system can receive user definitions of one or more evaluation library definitions, and the evaluation library definitions can define the core evaluation libraries and/or the user-defined evaluation libraries. The user definitions and/or the evaluation library definitions can be computer-readable code. The system can include user-defined evaluation libraries and core evaluation libraries in the listing of selectable evaluation libraries.

The system may regulate access to one or more evaluation libraries based on user permissions associated with a user. For example, a user may have organization credentials, personal identifiers, subscriptions, and/or other indicators associated with the user that can restrict and/or grant access to one or more evaluation libraries. The system may only list evaluation libraries in the listing of selectable evaluation libraries that correspond to the user permissions.

### Example Aspects Related to the Model Evaluation

The system may operate to evaluate multiple models based on an evaluation configuration associated with a defined modeling objective. To evaluate the models, the system may execute the models using an evaluation data set. The system may determine, for each of the models, overall values for each evaluation metric included in the evaluation library. For example, for each of the models, the system may use the evaluation library, the evaluation data set, and the outputs of the models to determine an overall value for each evaluation metric. The evaluation data set may include expected values. Expected values can include values associated with the actual outcomes the system is using the models to predict. For example, for a model that receives inputs and determines an estimated housing price, the system may have expected values that include housing prices of sold houses that correspond to the received inputs of the model. Determining overall values for evaluation metrics for models may include analyzing the output of the models with expected values included in the evaluation data set. The system may determine for each defined subset of the evaluation data set, subset values for each of the evaluation metrics.

When an evaluation configuration includes a plurality of evaluation data sets, a plurality of evaluation libraries, and/or a plurality of subset definitions, the system can determine values for some or all of each of the combinations of, for example, subsets of evaluation data. Thus, for example, various subsets can be compared across multiple dimensions of data field values, and/or the like.

### Example Aspects Related to LLM Functionality

According to various implementations, the system can incorporate and/or communicate with one or more LLMs to perform various functions. Such communications may include, for example, a context associated with an aspect or analysis being performed by the system, a user-generated prompt, an engineered prompt, prompt and response examples, example or actual data, and/or the like. For example, the system may employ an LLM, via providing an input to, and receiving an output from, the LLM. The output from the LLM may be parsed and/or a format of the output may be updated to be usable for various aspects of the system.

The system may employ an LLM to, for example, in whole or in part, determine a modeling objective (e.g., based on one or more models and/or other information), identify additional models that may be related to the modeling objective, determine an evaluation configuration, determine an evaluation data set, determine an evaluation library, determine subset definitions and/or subsets, determine one or more evaluation metrics, evaluate the results of model evaluations (e.g., evaluate determined evaluation metric values), and/or the like.

### Example Aspects Related to the User Interfaces

The system can include interactive graphical user interfaces that enable adding and configuring evaluation configurations. For example, the user interfaces can receive one or more inputs from the interactive graphical user interface and select modeling objectives, specify evaluation data sets, specify evaluation libraries, and specify subsets. The system can output the results of an evaluation configuration to the user interface. For example, the system can output the results of an evaluation configuration for each of the models associated with the modeling objective in a consistent format. The outputs can include, for example, graphical visualizations such as charts, tables, lists, and/or the like. The visualizations may be user defined, and be specified by the evaluation library (and/or other aspects of the system). The system can output the results of an evaluation configuration on a model for each of the defined subsets in a consistent format. Additionally, when an evaluation configuration includes a plurality of evaluation data sets, a plurality of evaluation libraries, and/or a plurality of subset definitions, the system can output and display various for some or all of each of the combinations of, for example, subsets of evaluation data. Thus, for example, various subsets can be displayed and compared across multiple dimensions of data field values, and/or the like.

### II. Example Model Evaluation System and Related Computing Environment

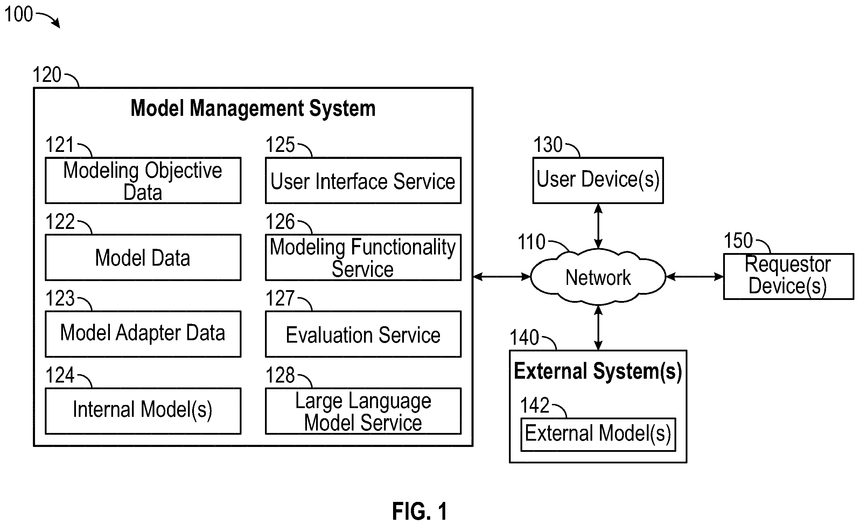

FIG. 1 illustrates an example computing environment 100 including a model management system 120 (referred to herein as "system 120"). The system 120 may include modeling objective data 121, model data 122, model adapter data 123, internal model(s) 124, a user interface service 125, a modeling functionality service 126, an evaluation service 127 and a large language model service 128. The system 120 may be connected via network 110 to other computing devices, such as user device(s) 130, external system(s) 140, and requestor device(s) 150. External system(s) 140 may include external model(s) 142. For example, user device(s) 130 may transmit a request to the system 120, to execute one or more models located on external system(s) 140. The system 120 may receive the request from the user device(s) 130 and in response, transmit a request to the external system(s) 140 to execute one or more external model(s) 142. The external system(s) 140 may receive the request from the system 120 and in response, execute one or more external model(s) 142, and transmit to the user device(s) 130, requestor device(s) 150, and/or the system 120, information based on the results of the external model(s) 142.

Modeling objective data 121 can include data representing any task or objective, such as a processing, prediction, estimation, and/or an analysis task (and/or the like). Modeling objective data 121 can include instructions associated with one or more internal model(s) 124 and/or instructions associated with one or more external models, such as external model(s) 142 of external system(s) 140. The instructions can be configured to execute a portion of, or the entire task or objective associated with a defined modeling objective. The modeling objective data 121 can include, for example, specifications regarding how input data from user device(s) 130, requestor device(s) 150, and/or applications, should be provided to the system 120 (and/or consumed by one or more models associated with the system 120). Additionally, and/or alternatively, modeling objective data 121 can include specifications regarding how output data to user device(s) 130, requestor device(s) 150, and/or applications should be provided for a defined modeling objective. Such input and output specifications included as part of modeling objective data 121 can include, for example, data formats, data schemas, data types, and/or the like.

Such input and output specifications of modeling objective data 121 may be referred to, in one implementation, as an objective API ("application programming interface"). Further, configuration of an objective API can, define how inputs and outputs to a model should be mapped to an ontology of the system 120 when invoked interactively. For example, a defined modeling objective may include instructions for determining housing prices in the United States. Inputs to such a modeling objective, as defined by the modeling objective data 121 can include real world properties such as house location, number of rooms, square footage, and recently sold home prices, while the modeling objective output as defined by the modeling objective data 121 can include an estimated house price.

Model data 122 can include object data representing characteristics of one or more models within the system 120, such as internal model(s) 124. Additionally, and/or alternatively, model data 122 can include object data representing characteristics of associated models hosted on third-party platforms, such as external model(s) 142. Object data can include, for example, data sources, instructions, permissions, lineage, governance, auditability, and an allocation of resources for a model. Advantageously, model data 122 is agnostic with models internal to the system 120 as well as models externally hosted by a third-party platform because the system 120 treats model data 122 defined for internal and external models as similar assets. For example, substantiation and configuration of internal and external models, as well as user permissions may be included as part of an internal and external model's model data 122.

The model adapter data 123 can include specific instructions defining implementation criteria of a selected internal or external model for a defined modeling objective. Instructions can range in scope and quantity based on the associated modeling objective data 121. For example, instructions within model adapter data 123 can include loading, saving, or execution instructions. Instructions may optionally include permissioning criteria, limiting access to select users for one or more internal model(s) 124 and/or external model(s) 142. The model adapter data 123 may include additional instructions for configuring the functionality and communication between an internal and/or external model and a defined modeling objective. The model adapter data 123 can further include definitions and/or formats for expected input data types and output data types of a model, specifications for parameters or properties of a model, and/or the like. For example, input data types and output data types can include a string, text, binary, floating point, character, Boolean, timestamp, and/or date. Additionally, definitions and/or formats for expected input data types and output data types can include, for example, the number of columns for input or output data, column header information, whether the input or output data is in tabular form or from a filesystem (and/or in another data format), and how the selected model should receive and process new input data (such as for example, via a batch or live operation). The model adapter data 123 can further include scheduling instructions for dependencies, such as a list of necessary data to be accessed and consumed by the selected model, or specific rules based on the operating platform of the model (e.g., python) without requiring that the model operate in the specific operating platform environment.

Additionally, the model adapter data 123 can include instructions governing specific criteria for input and output data of a selected model within the defined modeling objective, called "fine-tuned" data. Examples of fine-tuned data can include domain specific language tailored to the selected model or training data that can manually adjust one or more characteristics or functions of a selected model to better incorporate the selected model into a specific modeling objective.

The model adapter data 123 can be represented by, for example, a set of binary files or generic files determining the interaction between the system 120 and a selected model for a defined modeling objective. Additionally, model adapter data 123 can provide more than one model adapter configuration for a selected model, thereby providing the user with the flexibility to define a plurality of distinct instructions for incorporating a model into a defined modeling objective. Advantageously, the ability to configure model adapter data 123 can provide a user with the means necessary to quickly generate complex binary files or generic files that are required to incorporate internal or external models into a system 120 for a defined modeling objective.

Internal model(s) 124 can be a datastore and/or other data structure storing one or more models. For example, internal model(s) 124 can include data representing a realworld event, a system or sub-system, a behavior, and/or a natural phenomenon. When executed, internal model(s) 124 may receive input data and/or generate output data and based on a defined modeling objective. Internal model(s) 124 may receive input data from for example, a second internal model, user device(s) 130, requestor device(s) 150, external model(s) 142 and/or another system as defined by modeling objective data 121, based on a request to execute a defined modeling objective.

User interface service 125 may allow the system 120 to interact with the user. User interface service 125 may generate a graphical user interface ("GUI") displayed on a client device, such as user device(s) 130. User interface service 125 may also receive data entered by a user into a client device, such as user device(s) 130, and may store and/or forward it to the other various components of the system 120.

The modeling functionality service 126 may send and receive data to/from user device(s) 130, external system(s) 140, and/or requestor device(s) 150. For example, modeling functionality service 126 may connect to external system(s) 140 through an application programming interface ("API") and retrieve or submit data to/from a one or more external model(s) 142 maintained on external system(s) 140 through appropriate API calls. Similarly, modeling functionality service 126 may receive data from an API from requestor device(s) 150 through appropriate API calls. Additionally, modeling functionality service 126 can execute steps and/or functions associated with a modeling objective. For example, based on a request from requestor device(s) 150, modeling functionality service 126 may provide input data to one or more internal model(s) 124, and/or one or more external model(s) 142, and execute steps and/or functions according to modeling objective data 121 associated with the request.

Further, modeling functionality service 126 may promote one or more selected models to a staged release version and/or a production released version within the system 120. When the modeling functionality service 126 designates the selected model as a production released version, the system 120 may automatically deploy the newly promoted model within each modeling objective where the selected model is labeled for production use. For example, a user may interact with a GUI to promote one or more models to a staged release and/or a production released version. The modeling functionality service 126 may receive and execute the promotion request from user interface service 125. When the modeling functionality service 126 designates the selected model as a production released version, the modeling functionality service 126 may automatically deploy the newly promoted model within each modeling objective where the selected model is labeled for production use.

The evaluation service 127 can provide a model evaluation environment and related functionality, as described herein, for a defined modeling objective. The evaluation service 127 can allow a user to evaluate one or more configured models within a defined modeling objective. The evaluation service 127 may establish a model evaluation environment for internal model(s) 124 and/or external model(s) 142. When external model(s) 142 are implemented as part of the evaluation service 127, a URL may be generated by the evaluation service 127, allowing the external model(s) 142 to easily access the model evaluation.

The evaluation service 127 can associate an evaluation configuration with a defined modeling objective. The evaluation service 127 may operate to evaluate multiple models based on the evaluation configuration associated with a defined modeling objective. The evaluation service 127 may allow for the selection of data (referred to herein as the "evaluation data set") that is to be used in an evaluation configuration to evaluate models associated with the defined modeling objective. The evaluation data set can include model input data, model output data, expected values, and/or other data used in model evaluation. The evaluation service 127 may allow for evaluation configurations to be implemented using stored evaluation metrics. The evaluation metrics can include the computer code and functions used to process and evaluate the models. The evaluation metrics can be compiled into an evaluation library and used to execute the evaluation configuration. The selection of an evaluation library can be tailored to the needs of the defined modeling objective and to the evaluation data set used in the evaluation configuration. For example, the defined modeling objective or the evaluation data set may require specific evaluation metrics.

The evaluation service 127 may allow for a definition of subsets of the evaluation data sets used in the evaluation configuration. For example, the system may allow for a selection of data buckets, data ranges, a number of subsets, and/or the like, to partition an evaluation data set. The system may evaluate the models across the subsets.

The evaluation service 127 can update the evaluation configuration. For example, the evaluation service 127 may receive a new or updated model associated with a modeling objective (e.g., the new or updated model may be submitted to or received by the evaluation service 127). The evaluation service 127 can automatically evaluate the new or updated model using the evaluation data sets and evaluation libraries associated with the evaluation configuration.

In various implementations, an evaluation configuration can include a plurality of evaluation data sets, a plurality of evaluation libraries, a plurality of subset definitions (e.g., that may each identify respective subsets of evaluation data), and/or the like.

The large language model service 128 can provide various LLM-related functionality of the system 120. The large language model service 128 may, for example, receive inputs to, and provide outputs from, one or more internal or external LLMs for various LLM functionality of the system described herein. In various implementations, the large language model service 128, and/or one or more LLMs accessible via the large language model service 128, may be locally hosted, cloud managed, accessed via one or more APIs, and/or any combination of the foregoing and/or the like. For example, a user may interact with a user interface provided by the system 120, and request to query information associated with a defined modeling objective. The large language model service 128 may receive the query, and transmit results based on the query to a user interface of the system 120.

Users may use user device(s) 130 to view and/or interact with a GUI provided by the user interface service 125. For example, the user device(s) 130 can include a wide variety of computing devices, including personal computing devices, terminal computing devices, laptop computing devices, tablet computing devices, electronic reader devices, mobile devices (e.g., desktop computer, notebook computer, smartphone, or any other type of computing device) and associated software (e.g. a browser capable of rendering output from information provided by, for example, user interface service 125).

The external system(s) 140 can be a third-party server and/or data store implemented as a computer system having logical elements. In an implementation, the logical elements may comprise program instructions recorded on one or more machine-readable storage media. Alternatively, the logical elements may be implemented in hardware, firmware, or a combination thereof. The external system(s) 140 may include one or more modules. In one example, the external system(s) 140 can include external model(s) 142. External model(s) 142 can be located external to the system 120, for example within one or more external system(s) 140. External model(s) 142 can be functionally similar or the same as internal model(s) 124 and/or the large language model service 128, and may be accessed, for example, via one or more APIs and/or the like.

Requestor device(s) 150 can include third-party servers or data stores implemented as a computer system having logical elements. In an implementation, the logical elements may comprise program instructions recorded on one or more machine-readable storage media. Alternatively, the logical elements may be implemented in hardware, firmware, or a combination thereof. Requestor device(s) 150 can request data from or transmit data to one or more modules of a system 120. For example, requestor device(s) 150 may transmit a request to execute a defined modeling objective and/or request output data from an executed model.

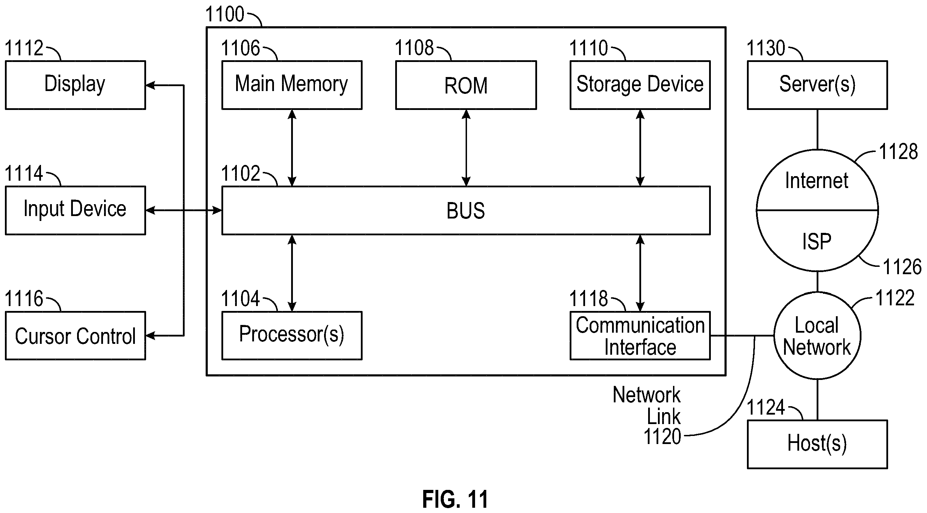

The network 110 can include any one or more communications networks, such as the Internet. The network 110 may be any combination of local area networks ("LAN") and/or a wireless area networks ("WAN") or the like. Accordingly, various components of the computing environment 100, including the system 120, can communicate with one another directly or indirectly via any appropriate communications links and/or networks, such as network 110 (e.g., one or more communications links, one or more computer networks, one or more wired or wireless connections, the Internet, any combination of the foregoing, and/or the like). Similarly, the various components (e.g., as described below) of the system 120 and the computing environment 100 may, in various implementations, communicate with one another directly or indirectly via any appropriate communications links (e.g., one or more communications links, one or more computer networks, one or more wired or wireless connections, the Internet, any combination of the foregoing, and/or the like). FIG. 11, described below, provides additional examples of aspects of implementations of such components of the computing environment 100, the system 120, and the like.

### III. Example Functionality of the Model Management System

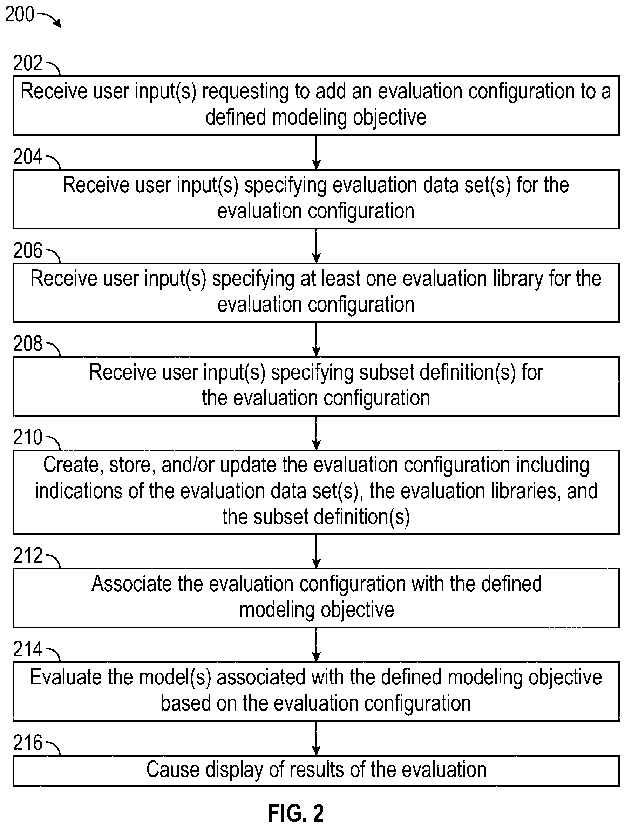

FIGS. 2-7 show flow charts illustrating example operations of the system 120 (and/or various other aspects of the example computing environment 100), according to various embodiments. The blocks of the flow charts illustrate example implementations, and in various other implementations various blocks may be rearranged, optional, and/or omitted, and/or additional block may be added. In various embodiments, the example operations of the system illustrated in FIGS. 2-7 may be computer-implemented, for example, by the one or more aspects of the system 120, various other aspects of the example computing environment 100, and/or the like.

FIG. 2 is a flow chart depicting an example process 200 for selecting and configuring an evaluation configuration as part of a system 120. As noted above, the system may operate to evaluate multiple models based on the evaluation configuration associated with a defined modeling objective. The system may allow for the selection of data (referred to herein as the "evaluation data set") that is to be used in an evaluation configuration to evaluate models associated with the defined modeling objective. The evaluation data set can include model input data, model output data, expected values, and/or other data used in model evaluation. The system may allow for evaluation configurations to be implemented using stored evaluation metrics. The evaluation metrics can include the computer code and functions used to process and evaluate the models. The evaluation metrics can be compiled into an evaluation library and used to execute the evaluation configuration. The selection of an evaluation library can be tailored to the needs of the defined modeling objective and to the evaluation data set used in the evaluation configuration. For example, the defined modeling objective or the evaluation data set may require specific evaluation metrics.

The system may allow for a definition of subsets of the evaluation data sets used in the evaluation configuration. For example, the system may allow for a selection of data buckets, data ranges, a number of subsets, and/or the like, to partition an evaluation data set. The system may evaluate the models across the subsets.

The system can update the evaluation configuration. For example, the system may receive a new or updated model associated with a modeling objective (e.g., the new or updated model may be submitted to or received by the system). The system can automatically evaluate the new or updated model using the evaluation data sets and evaluation libraries associated with the evaluation configuration.

The system can include interactive graphical user interfaces that enable adding and configuring evaluation configurations. For example, the user interfaces can receive one or more inputs from the interactive graphical user interface and select modeling objectives, specify evaluation data sets, specify evaluation libraries, and specify subsets. The system can output the results of an evaluation configuration to the user interface. For example, the system can output the results of an evaluation configuration for each of the models associated with the modeling objective in a consistent format. The outputs can include, for example, graphical visualizations such as charts, tables, lists, and/or the like. The visualizations may be user defined, and be specified by the evaluation library (and/or other aspects of the system). The system can output the results of an evaluation configuration on a model for each of the defined subsets in a consistent format. Additionally, when an evaluation configuration includes a plurality of evaluation data sets, a plurality of evaluation libraries, and/or a plurality of subset definitions, the system can output and display various for some or all of each of the combinations of, for example, subsets of evaluation data. Thus, for example, various subsets can be displayed and compared across multiple dimensions of data field values, and/or the like.

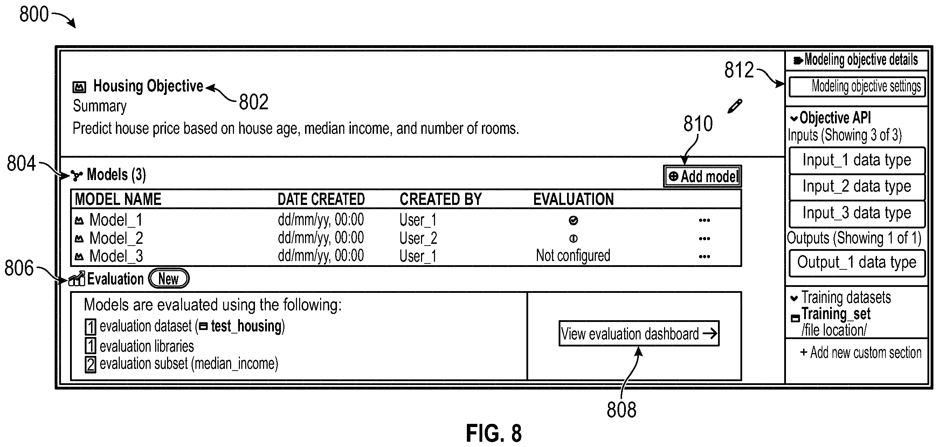

At block 202, the system receives one or more user input(s) requesting to add an evaluation configuration to a defined modeling objective. For example, a first user input requesting to add an evaluation configuration to a defined modeling objective (and subsequent user input(s)) may be received by the system from one or more user device(s) 130 via user interface service 125. The defined modeling objective can be associated with one or more model(s). The model(s) may be, for example, located within the system such as internal model(s) 124 and/or located externally, such one or more external model(s) 142 located on external system(s) 140. Example interactive graphical user interface functionality related to receiving user input(s) requesting to add an evaluation configuration to a defined modeling objective is also described herein in reference to, for example, FIG. 8.

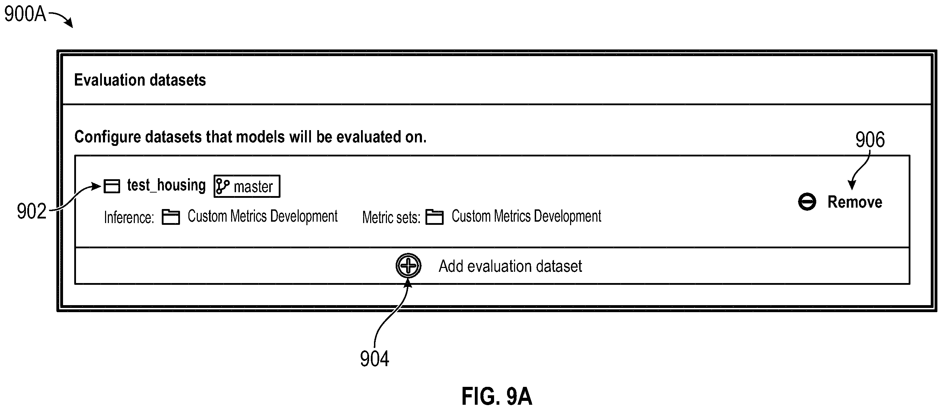

At block 204, the system receives one or more user input(s) specifying one or more evaluation data set(s) for the evaluation configuration. For example, the system can receive a second user input from one or more user device(s) 130 via user interface service 125 specifying at least a first evaluation data set for the evaluation configuration. Example interactive graphical user interface functionality related to receiving user input(s) specifying evaluation data set(s) for the evaluation configuration is also described herein in reference to, for example, FIG. 9A.

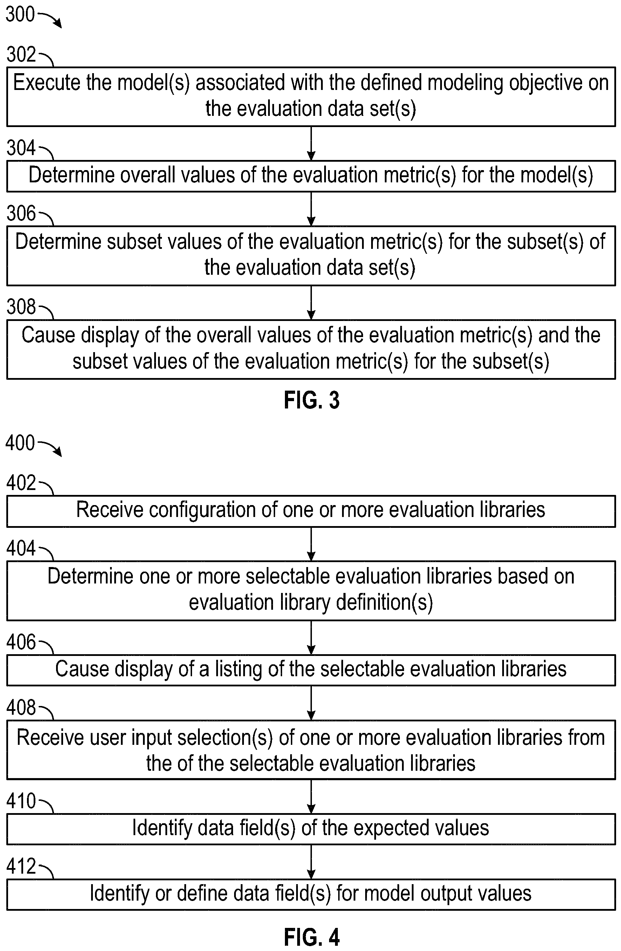

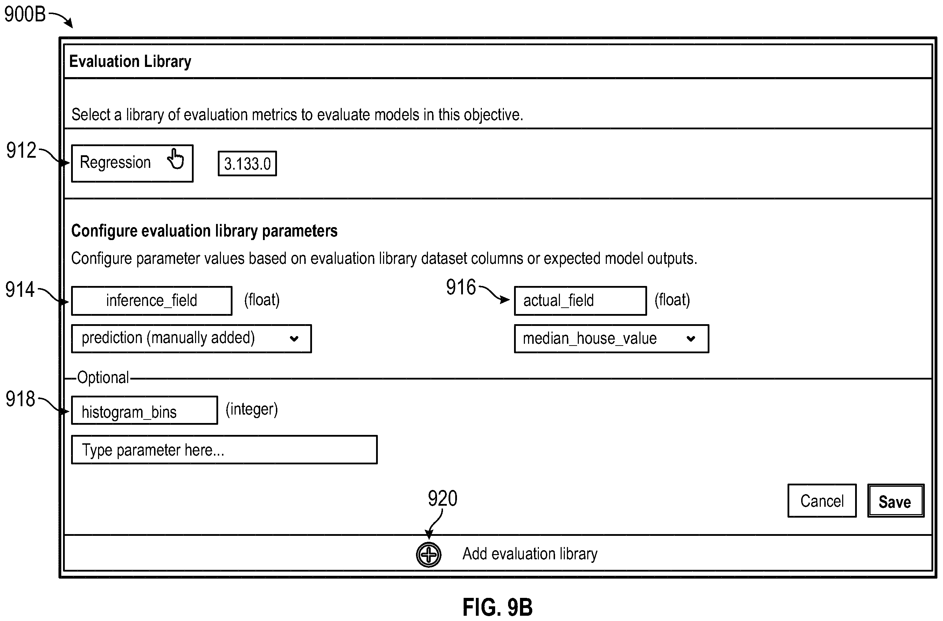

At block 206, the system receives one or more user input(s) specifying one or more evaluation libraries for the evaluation configuration. For example, the system can receive a third user input from one or more user device(s) 130 via user interface service 125 specifying at least a first evaluation library for the evaluation configuration. The process of specifying one or more evaluation libraries for the evaluation configuration is described in further detail with respect to FIG. 4. Example interactive graphical user interface functionality related to receiving user input(s) specifying evaluation libraries for the evaluation configuration is also described herein in reference to, for example, FIG. 9B.

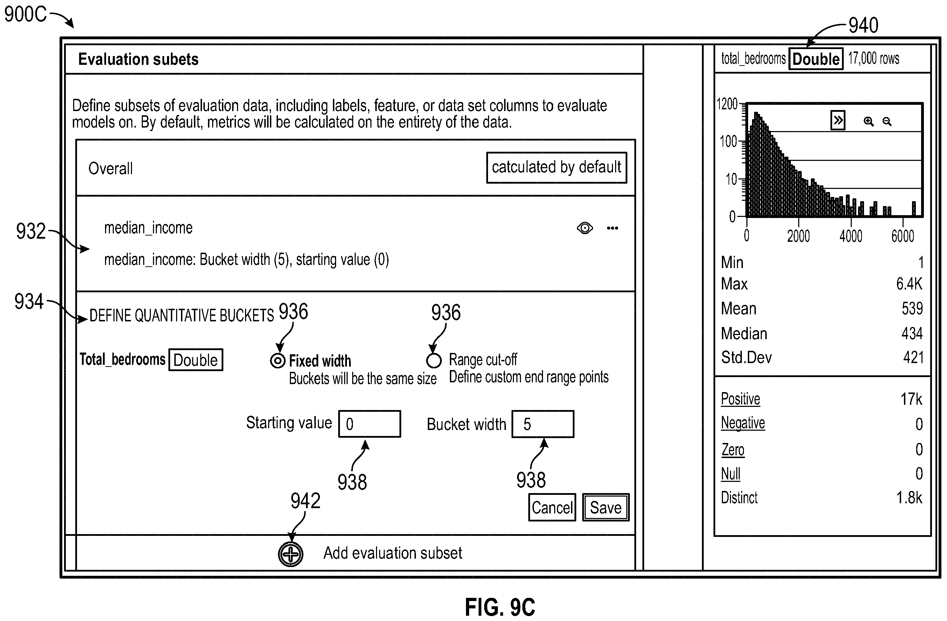

At block 208, the system receives one or more user input(s) specifying one or more subset definition(s) for the evaluation configuration. For example, the system can receive a fourth user input from one or more user device(s) 130 via user interface service 125 specifying a first subset definition identifying a first plurality of subsets of the first evaluation data set. Example interactive graphical user interface functionality related to receiving user input(s) specifying subset definition(s) for the evaluation configuration is also described herein in reference to, for example, FIG. 9C.

At block 210, the system creates, stores, and/or updates the evaluation configuration including indications of the evaluation data set(s), the evaluation libraries, and the subset definition(s). For example, the system can create, store, and/or update the evaluation configuration with indications of the first evaluation data set, the first evaluation library, and the first subset definition.

At block 212, they system associates the evaluation configuration with the defined modeling objective. For example, the system can associate the first evaluation data set, the first evaluation library, and the first subset definition with one or more of the model(s) associated with the modeling objective.

At block 214, the system evaluates the model(s) associated with the defined modeling objective based on the evaluation configuration. For example, the system can evaluate the model(s) associated with the defined modeling objective using the first evaluation data set, the first evaluation library, and the first subset definition. The process of evaluating the model(s) associated with the defined modeling objective based on the evaluation configuration is described in further detail with respect to FIG. 3.

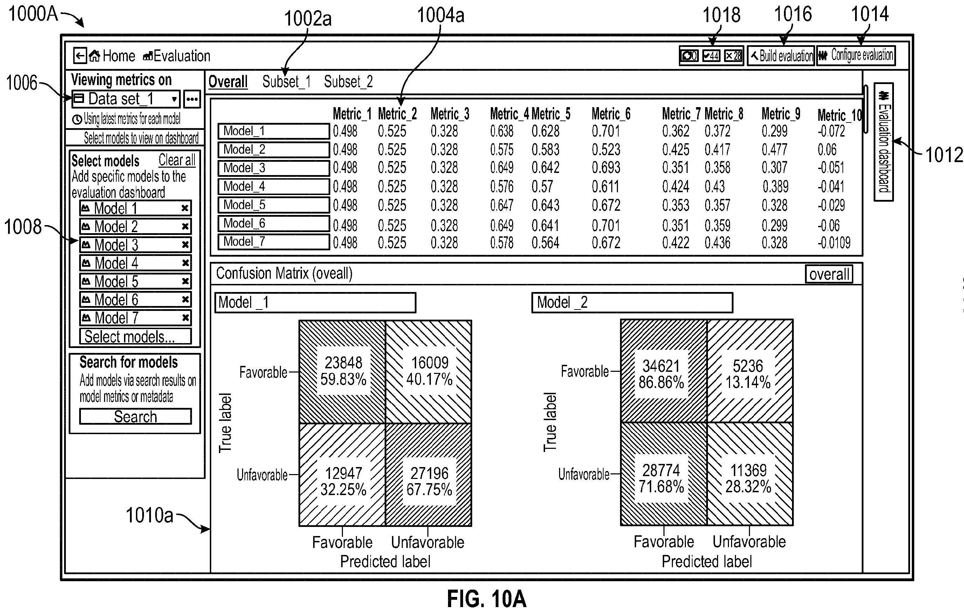

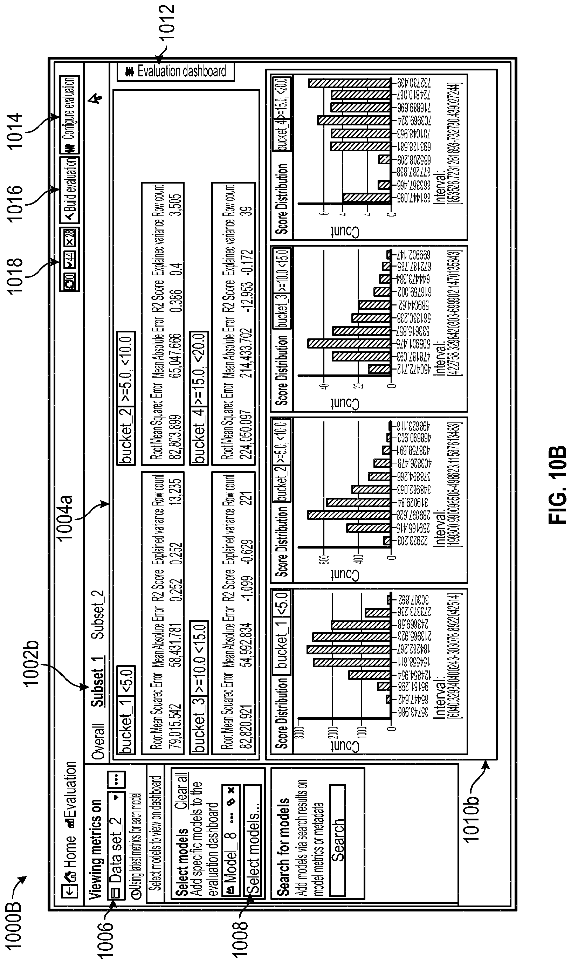

At block 216, the system causes a display of results of the evaluation. For example, the system can cause display of results of the evaluation to one or more user device(s) 130 via user interface service 125. The results of the evaluation can include the overall values of the first one or more evaluation metrics for each of the model(s). The results of the evaluation can include the subset values of the first one or more evaluation metrics for each of the first plurality of subsets for each of the model(s). Example interactive graphical user interface functionality related to displaying results of the evaluation also described herein in reference to, for example, FIGS. 10A-10B. In an extension of the above described embodiments, the system may select a model based on the evaluation of the models and execute the model on an implementation dataset. The system may then display output values based on the execution of the selected model on the implementation dataset. The implementation dataset may be a dataset for which expected values of evaluation metrics are not known prior to execution of the selected model. The implementation dataset may be a dataset that is larger than the evaluation dataset and may include, for example, at least 10, 100, or 1000 times the amount of data as the evaluation data sets. Evaluation of models according to the present disclosure prior to execution of models on further datasets provides a computationally efficient means of achieving useful and accurate model outputs.

FIG. 3 is a flow chart depicting an example process 300 evaluating the model(s) associated with the defined modeling objective based on the evaluation configuration as part of a system 120. As noted above, the system may operate to evaluate multiple models based on an evaluation configuration associated with a defined modeling objective. To evaluate the models, the system may execute the models using an evaluation data set. The system may determine, for each of the models, overall values for each evaluation metric included in the evaluation library. For example, for each of the models, the system may use the evaluation library, the evaluation data set, and the outputs of the models to determine an overall value for each evaluation metric. The evaluation data set may include expected values. Expected values can include values associated with the actual outcomes the system is using the models to predict. For example, for a model that receives inputs and determines an estimated housing price, the system may have expected values that include housing prices of sold houses that correspond to the received inputs of the model. Determining overall values for evaluation metrics for models may include analyzing the output of the models with expected values included in the evaluation data set. The system may determine for each defined subset of the evaluation data set, subset values for each of the evaluation metrics.

As noted above, when an evaluation configuration includes a plurality of evaluation data sets, a plurality of evaluation libraries, and/or a plurality of subset definitions, the system can determine values for some or all of each of the combinations of, for example, subsets of evaluation data. Thus, for example, various subsets can be compared across multiple dimensions of data field values, and/or the like.

At block 302, the system executes the model(s) associated with the defined modeling objective on the evaluation data set(s). For example, the system can execute each of the one or more models associated with the defined modeling objective on a first evaluation data set.

At block 304, the system determines overall values of the evaluation metric(s) for the model(s). For example, the system can determine, for each of the one or more models associated with the modeling objective, and based on the first evaluation library and outputs of each of the one or more models, overall values of the first one or more evaluation metrics.

At block 306, the system determines subset values of the evaluation metric(s) for the subset(s) of the evaluation data set(s). For example, the system can determine, for each of the first plurality of subsets of the first evaluation data set, and based on the first evaluation library and outputs of each of the one or more models, subset values of the first one or more evaluation metrics.

At block 308, the system causes a display of results of the evaluation, as also described above in reference to block 216 of FIG. 2. For example, the system can cause display of results of the evaluation to one or more user device(s) 130 via user interface service 125. The results of the evaluation can include the overall values of the first one or more evaluation metrics for each of the model(s). The results of the evaluation can include the subset values of the first one or more evaluation metrics for each of the first plurality of subsets for each of the model(s). Example interactive graphical user interface functionality related to displaying results of the evaluation also described herein in reference to, for example, FIGS. 10A-10B.

FIG. 4 is a flow chart depicting an example process 400 for specifying one or more evaluation libraries for the evaluation configuration. As noted above, the evaluation libraries can define the evaluation metrics used in the evaluation configuration to evaluate the models. The evaluation libraries can be selectable. For example, the system can receive selections of evaluation libraries through interactive graphical user interfaces, such as user interface service 125. The system can provide a listing of selectable evaluation libraries to the interactive graphical user interface. The listing of selectable evaluation libraries can be searchable. For example, the listing of selectable evaluation libraries may be searched using an interactive graphical interface. The system can determine the listing of selectable evaluation libraries based on one or more evaluation library definitions. The evaluation library definitions can include descriptions of the evaluation libraries, identifications of user definable data fields, and/or specifications for determining related evaluation metrics. The descriptions of the evaluation libraries can be determined based on parsable descriptions of the library definitions.

As noted above, the system can identify and/or define data within an evaluation data set based on a specifying of an evaluation library. For example, the system may receive a specification of an evaluation library and identify and/or define expected values and model outputs in an evaluation data set. A specification of an evaluation library can be received through an interactive graphical interface, such as through the listing of selectable evaluation libraries.

As noted above, an evaluation library can be preintegrated, preloaded, or predefined in the system (referred to herein as a "core evaluation library"). An evaluation library can also be user created (referred to herein as a "user-defined evaluation library"). For example, the system can receive user definitions of one or more evaluation library definitions, and the evaluation library definitions can define the core evaluation libraries and/or the user-defined evaluation libraries. The user definitions and/or the evaluation library definitions can be computer-readable code. The system can include user-defined evaluation libraries and core evaluation libraries in the listing of selectable evaluation libraries.

As noted above, the system may regulate access to one or more evaluation libraries based on user permissions associated with a user. For example, a user may have organization credentials, personal identifiers, subscriptions, and/or other indicators associated with the user that can restrict and/or grant access to one or more evaluation libraries. The system may only list evaluation libraries in the listing of selectable evaluation libraries that correspond to the user permissions.

At block 402, the system receives configurations of one more evaluation libraries. For example, the system can receive configurations of core evaluation libraries and/or user-defined evaluation libraries. The evaluation library configurations can include the evaluation metrics used associated with each evaluation library.

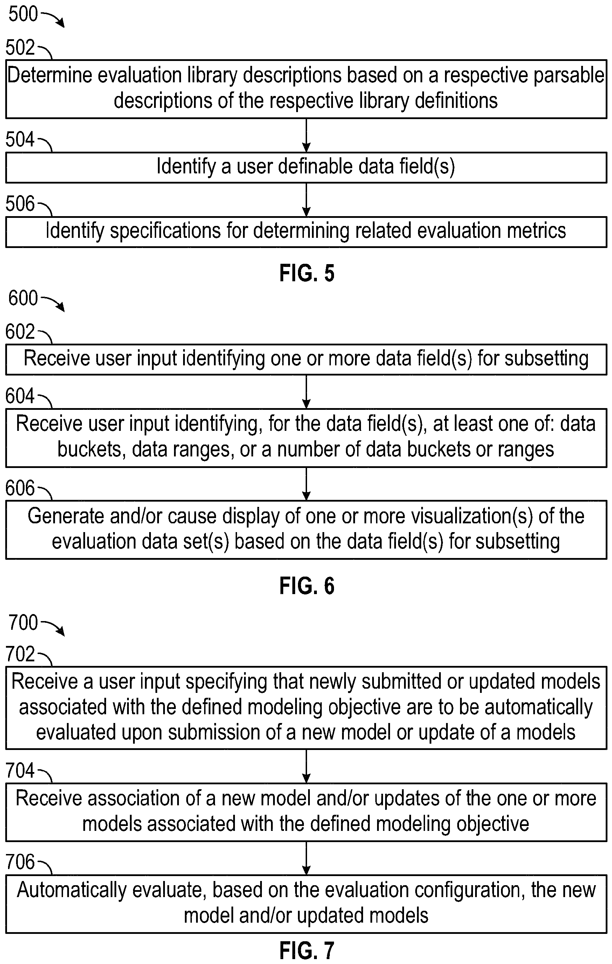

At block 404, the system determines one or more selectable evaluation libraries based on one or more evaluation library definition(s). For example, the system can determine one or more selectable core evaluation libraries and/or one or more user-defined evaluation libraries based on one or more evaluation library definitions. As described further with respect to FIG. 5, the evaluation library definitions can include evaluation library descriptions, user definable data fields, and specifications for determining related evaluation metrics.

At block 406, the system causes display of a listing of the selectable evaluation libraries. For example, the system can cause display of the listing of the selectable core evaluation libraries and/or user-defined evaluation libraries to one or more user device(s) 130 via user interface service 125. Example interactive graphical user interface functionality related to the display of a listing of the selectable evaluation libraries is also described herein in reference to, for example, FIG. 9B.

At block 408, the system receives one or more user input selection(s) of one or more evaluation libraries for the selectable evaluation libraries. For example, the system can receive user input selection(s) from one or more user device(s) 130 via user interface service 125 selecting one or more core evaluation libraries and/or one or more user-defined evaluation libraries.

At block 410, the system identifies data field(s) of the expected values. For example, the system can identify expected values in one or more evaluation data set(s) for each of the selected core evaluation libraries and/or selected user-defined evaluation libraries. Example interactive graphical user interface functionality related to receiving user input(s) identifying expected values in the evaluation data set(s) is also described herein in reference to, for example, FIG. 9B.

At block 412, the system identifies or defines one or more data field(s) for model output values. For example, the system can identify or define data field(s) in one or more evaluation data set(s) for output values for each of the selected core evaluation libraries and/or selected user-defined evaluation libraries. Example interactive graphical user interface functionality related to receiving user input(s) identifying or defining data field(s) for the evaluation configuration is also described herein in reference to, for example, FIG. 9B.

FIG. 5 is a flow chart depicting an example process 500 for determining an evaluation library definition. At block 502, the system determines an evaluation library description based on a respective parsable descriptions of the respective library definitions. A parsable description of the respective library definitions can be parsable computer code the system can parse to populate portions of various user interfaces of the system with information of an evaluation library. The following is example pseudo-code of a parsable description of a respective library definition:

```
***
                   :display-name: Evaluation_Library_1
                   :description: Description of the use and/or functionality
                                 of Evaluation_Library_1
                   :param parameter_1: Description of the parameter_1
                   :param parameter_2: Description of the paremter_2
                   :metric metric_1: Description of the metric_1
                   :metric metric_2: Description of the metric_2
                   :metric metric_3: Description of the metric_3
                   ***
```

As illustrated by the example pseudo-code, the evaluation library definition can be used to specify an evaluation library name, a description of the evaluation library, a first parameter description, a second parameter description, a first metric description, a second metric description, and a third metric description. The system can read and/or parse the evaluation library definition to determine this information when implementing the evaluation library, and can display this information on a portion of one or more user interfaces of the system, as described herein.

At block 504, the system identifies one or more user definable data fields. A user definable field can be portions of computer code that call for user input definitions. The user input definitions can be from one or more user device(s) 130 via user interface service 125. The following is example pseudo-code of user definable data fields:

```
parameter_1: Field[str]
                   parmeter_2: Field[str]
```

As illustrated by the example pseudo-code, the evaluation library definition can be used to define data fields of one or more parameters, such as a first parameter and a second parameter. The system can read and/or parse the evaluation library definition to determine this information when implementing the evaluation library. For example, the first parameter may be model output values and the second parameter may be expected model output values. The user definable data fields may allow the system to receive one or more user inputs to define the data fields of the model output values and the data fields of the expected model output values.

At block 506, the system identifies specifications for determining related evaluation metrics. The specifications for determining related evaluation metrics can be portions of computer code the define the data structures and functions used to determine the evaluation metrics of an evaluation library. The following is example pseudo-code of the specification for determining related evaluation metrics:

```
                   # Preprocess
                   define data_structure_1
                   define data_structure_2
                   define data_structure_3
                   # Metric_1
                   def compute_metric_1_function (model_output,
             expected_ouput):
                         ... return metric_value
```

As illustrated by the example pseudo-code, the evaluation library definition can be used to identify data structures and functions for determining metrics, e.g., three data structures and one function used in determining a first metric. The system can read and/or parse the evaluation library definition to determine this information when implementing the evaluation library. The data structures and functions can identify data fields and inputs needed to determine a metric for an evaluation library.

FIG. 6 is a flow chart depicting an example process 600 for specifying one or more subset definition(s) for the evaluation configuration. As noted above, the system may allow for a definition of subsets of the evaluation data sets used in the evaluation configuration. For example, the system may allow for a selection of data buckets, data ranges, a number of subsets, and/or the like, to partition an evaluation data set. The system may evaluate the models across the subsets.

As noted above, the system can update the evaluation configuration. For example, the system may receive a new or updated model associated with a modeling objective (e.g., the new or updated model may be submitted to or received by the system). The system can automatically evaluate the new or updated model using the evaluation data sets and evaluation libraries associated with the evaluation configuration.

As noted above, in various implementations, an evaluation configuration can include a plurality of evaluation data sets, a plurality of evaluation libraries, a plurality of subset definitions (e.g., that may each identify respective subsets of evaluation data), and/or the like.

At block 602, the system receives user input identifying one or more data field(s) for subsetting. For example, the system can receive input from one or more user device(s) 130 via user interface service 125 identifying at least a first data field for subsetting in at least a first evaluation data set. Example interactive graphical user interface functionality related to receiving user input identifying or data field(s) for subsetting is also described herein in reference to, for example, FIG. 9C.

At block 604, the system can receive input identifying from the data field(s), at least one of: data buckets, data ranges, or a number of data buckets or ranges. A data bucket can be a defined portion of an evaluation data set with an identified starting value within the evaluation data set and an identified bucket width. The starting value within the evaluation data set can be a specific data value the data bucket begins at. The bucket width can identify a number of data fields to include in the data bucket. The system can portion the subset into multiple data buckets using the identified data bucket. For example, the system can determine the subset should include multiple data buckets based on the identified starting value and identified bucket width. In some embodiments, the system can identify the starting value and bucket width based on user input specifying a number of buckets. For example, the system can receive input from one or more user device(s) 130 via user interface service 125 identifying five buckets for the subset. In this example, the system can determine the starting value and bucket width of to create five equally sized buckets of the first data field.

A range can include a custom starting value and ending value for the subset. For example, a range can specify a first specific data value the data the range begins at and a second specific data value the data the range ends at. The subset can include multiple ranges. For example, the system can receive input from one or more user device(s) 130 via user interface service 125 identifying a first data range with a first starting and ending value and a second data range with a second starting and ending value. Example interactive graphical user interface functionality related to receiving user input identifying data buckets, data ranges, or a number of data buckets or ranges is also described herein in reference to, for example, FIG. 9C.

At block 606, the system generates and/or causes display of one or more visualization(s) of the evaluation data set(s) based on the data field(s) for subsetting. For example, the system can cause display on one or more user device(s) 130 via user interface service 125 of an evaluation data set based on the first data field. Advantageously, a visualization of an evaluation data set based on a data field may allow for an understanding of the shape of the evaluation data set and subsets before running an evaluation configuration. For example, a visualization of an evaluation data set based on a data field may show that a first bucket or range of the subset has limited data input. In this example, a user may want to reconfigure the subset based on the visualization of the evaluation data set. Example interactive graphical user interface functionality related to displaying visualization(s) of the evaluation data set(s) based on the data field(s) for subsetting is also described herein in reference to, for example, FIG. 9C.

FIG. 7 is a flow chart depicting an example process 700 for automatically evaluating new and/or updated models in an evaluation configuration. Process 700 can be implemented in conjunction with process 200. At block 702, the system receives a user input specifying that newly submitted or updated models associated with the defined modeling objective are to be automatically evaluated upon submission of a new model or an update of models. For example, the system can receive a fifth user input from one or more user device(s) 130 via user interface service 125 specifying that newly submitted or updated models associated with the defined modeling objective are to be automatically evaluated upon submission of a new model or update of a models.

At block 704, the system receives an association of one or more new model(s) and/or one or more update(s) of the one or more model(s) associated with the defined modeling objective. For example, the defined modeling objective associated with an evaluation configuration can receive an update to a first associated model and/or a new association with a second associated model. Example interactive graphical user interface functionality related to receiving associations of new model(s) and/or update(s) of model(s) associated with the defined modeling objective is also described herein in reference to, for example, FIG. 8.

At block 706, the system automatically evaluates, based on the evaluation configuration, the new model(s) and/or the updated model(s) For example, the system can automatically evaluate the first associated model and the second associate model. The automatic evaluation can include the process 300 described in FIG. 3. Advantageously, process 700 can allow for an evaluation configuration to remain up to date without reevaluating models that have the system has already evaluated.

### IV. Example User Interfaces of an Evaluation Configuration Framework

FIGS. 8, 9A-9C, and 10A-10B illustrate example user interfaces of the system 120 as provided by, for example, user interface service 125. FIG. 8 illustrates an example user interface 800 permitting the user to select various criteria when defining a modeling objective and requesting to add an evaluation configuration to the defined modeling objective. The example user interface 800 illustrates various example functionality of the system described, for example, in reference to block 202 of process 200 and blocks 702 and 704 of process 700. Advantageously, the example user interface 800 may allow the user to define input type(s) and output type(s) for a defined modeling objective, add one or models to the defined modeling objective, provide a listing and interacting with, a plurality of models associated with the defined modeling objective, and/or request an evaluation configuration be added to the defined modeling objective. Example user interface 800 can include a modeling objective 802, a listing of models 804 that are associated with the modeling objective, an evaluation configuration summary 806, an evaluation configuration input selection 808, an add model input selection 810, and/or a data summary table 812.

The modeling objective 802 can include a title of the modeling objective and a summary of the modeling objective purpose. In the illustrated example, the modeling objective 802 includes the title, "Housing Objective" and the summary, "Predict house price based on house age, median income, and number of rooms." The modeling objective 802 can display any title and summary. For example, a user may set a different name and summary for the modeling objective 802.

The listing of models 804 can include a list of each model associated with the modeling objective. Each model in the listing of models 804 can include information about the model. In the illustrated example, three models are shown in the listing of models 804 along with the date the models were created, the user that created the models. Advantageously, the listing of models 804 can include an indication if the models have been evaluated by the evaluation configuration. The indication if the models have been evaluated can include indications that the evaluation was successful for the model, the evaluation failed for the model, the model has not been configured to be evaluated by the evaluation configuration, the model is currently being evaluated by the evaluation configuration, and the like.

The model input selection 810 can allow a user to add one or more additional models to the modeling objective. For example, a user can use model input selection 810 to add a new model, such as, for example, in reference to block 704 of process 700.

The evaluation configuration summary 806 can include a summary of the evaluation data sets being used by the evaluation configuration, such as the number of evaluation data sets and the name of the evaluation data sets. The evaluation configuration summary 806 can include a summary of the evaluation libraries being used by the evaluation configuration, such as the number of evaluation libraries and the name of the evaluation libraries. The evaluation configuration summary 806 can include a summary of the subset definitions being used by the evaluation configuration, such as the number of subset definitions and the name of the data fields of the evaluation data sets used for the subset definitions.

The data summary table 812 can include information on the data used by the modeling objective and the evaluation configuration, such as model input data locations and data types, model output data locations and data type, and the name, location, and data type of training data sets. The training sets can include expected model output values. Advantageously, the information displayed in the data summary table 812 can allow a user to easily access information used to specify evaluation data sets, specify evaluation libraries, and define subsets.

The evaluation configuration input selection 808 can allow a user to request to add an evaluation configuration to the defined modeling objective. The evaluation configuration input selection 808 illustrates various example functionality of the system described, for example, in reference to block 202 of process 200. The evaluation configuration input selection 808 can allow a user to edit or update the evaluation configuration. The evaluation configuration input selection 808, can allow a user to access example user interface 900A, example user interface 900B, example user interface 900C, example user interface 1000A, and/or example user interface 1000B, each described in further detail below.

FIGS. 9A-9C illustrate example user interfaces used for evaluation configurations. The example user interfaces in FIGS. 9A-9C can be displayed concurrently using user interface service 125. FIG. 9A illustrates example user interface 900A permitting the user to add one or more evaluation dataset(s) to an evaluation configuration. Example user interface 900A illustrates various example functionality of the system described, for example, in reference to block 204 of process 200. Example user interface 900A can include a listing of evaluation data sets 902, an add evaluation data set selection 904, and a remove evaluation data set selection 906.

The listing of evaluation data sets 902 can include the name and location of each specified evaluation data set. The listing of evaluation data sets 902 can also include other information on the specified evaluation data sets such as inference locations and locations of metric sets.

The add evaluation data set selection 904 can allow a user to add evaluation data sets to the evaluation configuration. Once added, the evaluation data sets will appear in the listing of evaluation data sets 902. The remove evaluation data set selection 906 can allow a user to remove evaluation data sets to the evaluation configuration. Once removed, the evaluation data sets will not appear in the listing of evaluation data sets 902.

FIG. 9B illustrates example user interface 900B permitting the user to add one or more evaluation libraries to an evaluation configuration. Example user interface 900A illustrates various example functionality of the system described, for example, in reference to block 206 of process 200 and blocks 406, 410, and 412 of process 400. Example user interface 900B can include a display of selected evaluation libraries 912, a model output field 914, an expected value field 916, an optional evaluation library parameter field 918, and an add evaluation library selection 920.

The display of selected evaluation libraries 912 can include the name and version of the selected evaluation libraries for an evaluation configuration. A user can identify or define data fields for model output values used by the selected evaluation libraries using the model output field 914, such as described, for example, in reference to block 412 of process 400. A user can identify data fields of expected values in the evaluation data set using expected value field 916, such as described, for example, in reference to block 410 of process 400. A user can use optional evaluation library parameter field 918 to further configure the selected evaluation library, such as specifying display parameters and the like.

The add evaluation library selection 920 can allow a user to add evaluation libraries to the evaluation configuration. The added evaluation libraries are then displayed in the displayed evaluation libraries 912. A user selection of the add evaluation library selection 920 can cause the system to display a listing of the selectable evaluation libraries, as described, for example, in reference to block 406 of process 400.

FIG. 9C illustrates example user interface 900C permitting the user to specify subset definitions for an evaluation configuration.. Example user interface 900C illustrates various example functionality of the system described, for example, in reference to block 208 of process 200 and blocks 602, 604, and 606 of process 600. Example user interface 900C can include a display of specified subsets 932, a subset configuration interface 934, an add evaluation subset selection 942, and a data field summary 940.

The display of specified subsets 932 can include a listing of user specified subsets. For each user specified subset, the display of specified subsets 932 can include a data field of the evaluation data set used for the subset. The illustrated example depicts that a user has specified the data field "median_income" to be used for a specified subset.

The add evaluation subset selection 942 can allow a user to identify and/or add data fields for subsetting, as described, for example, in reference to block 602 of process 600. Once a user has added a data field for a subset, the subset can be further specified using subset configuration interface 934.

The subset configuration interface 934 can allow a user to identify, for the data fields, at least one of: data buckets, data ranges, or a number of data buckets or ranges, as described, for example, in reference to block 604 of process 600. Subset configuration interface 934 can include subset type selections 936 and subset configuration fields 93 8. In the illustrated example, a bucket type of subset has been selected in the subset type selections 936, causing subset configuration interface 934 to provide fields for configuring bucket type subsets in the subset configuration fields 938. For example, a user may enter in the starting value and bucket width for the bucket type subset in configuration fields 938. Alternatively, a selection of a range type of subset in the subset type selections 936 can generate the subset configuration fields 938 to display data fields used for configuring range type subsets. While only bucket type subsets and range type subsets are shown in the subset type selections 936, more subset type selections may be displayed in the subset type selections 936, such as a number of data buckets selection, a number of ranges selection, an autogenerate subsets selection, and the like. Further, subset configuration fields 938 can include any fields for user input that are used to identify portions of the data fields used for subsetting. When the subset configuration interface 934 has been saved, the identified subset will appear in the display of specified subsets 932. For example, the illustrated example shows two user specified subsets. In this example, the "median_income" subset has been saved and is displayed in the display of specified subsets 932. In this example, the "Total_bedrooms" subset is depicted as pending a save in the subset configuration interface 934. It can be appreciated that, once the "Total_bedrooms" subset is saved, the "Total_bedrooms" will also appear in the display of specified subsets 932.

The data field summary 940 can display a visualization of an evaluation data set based on a data field for subsetting, as described, for example, in reference to block 606 of process 600. In the illustrated example, a visualization of the evaluation data set based on the "Total_bedrooms" data field is depicted. As noted above, the visualization of an evaluation data set based on a data field may allow for an understanding of the shape of the evaluation data set and subsets before running an evaluation configuration. For example, a visualization of an evaluation data set based on a data field may show that a first bucket or range of the subset has limited data input. In this example, a user may wish to reconfigure the subset based on the visualization of the evaluation data set.

FIGS. 10A-10B illustrate example user interfaces 1000A and 1000B for the display of results of evaluations. Example user interfaces 1000A and 1000B illustrate various example functionalities of the system described, for example, in reference to block 216 of process 200 and block 308 of process 300. Example user interfaces 1000A and 1000B can include a tab for selecting an evaluation view, such as tab 1002a and tab 1002b. Tab 1002a depicts an "Overall" tab selected at tab 1002a, configuring user interface 1000A to display the result of the overall values of the evaluation metrics. Tab 1002b depicts a "Subset_1" tab selected at tab 1002b, configuring user interface 1000B to display the result of a first subset values of the evaluation metrics.

Example user interfaces 1000A and 1000B can include an evaluation data set selection 1006. The evaluation data set selection 1006 can allow a user to select one or more specific evaluation data sets from the evaluation configuration. For example, if multiple evaluation data sets are specified for an evaluation configuration, evaluation data set selection 1006 can allow a user to select which evaluation data set to display results for in user interfaces 1000A and 1000B.

Example user interfaces 1000A and 1000B can include model selection 1008. The model selection 1008 can allow a user to select one or more specific models associated with the modeling objective of the evaluation configuration. For example, if multiple models are associated with the modeling objective of the evaluation configuration, model selection 1008 can allow a user to select which models to display results for in user interfaces 1000A and 1000B.

Example user interfaces 1000A and 1000B can include metric display 1004a and/or metric display 1004b. For example, metric display 1004a displays numerical results for each metric of the evaluation configuration and metric display 1004b displays numerical results for each metric for each bucket in a specified subset.

Example user interfaces 1000A and 1000B can include graphic display 1010a and/or graphic display 1010b. For example, graphic display 1010a displays graphic results of the evaluation for the overall evaluation data set and graphic display 1010b displays graphic results of the evaluation for a specified subset of the evaluation data set.

Example user interfaces 1000A and 1000B can include build indicators 1018. Build indicators 1018 can include indicators regarding the evaluation configurations. For example, build indicators can include indicators that evaluations are currently running, indicators that evaluations were successfully run, indicators that evaluation failed for one or more models, and/or the like.

Example user interfaces 1000A and 1000B can include a build evaluation selection 1016. The build evaluation selection 1016 can allow a user to receive more details of one or more builds of the evaluation configuration. For example, the build evaluation selection 1016 can allow a user to receive additional information on currently running evaluations, successful evaluations, and failed evaluations.

Example user interfaces 1000A and 1000B can include a configure evaluation selection 1014. The configure evaluation selection 1014 can allow a user to travers to user interfaces used for evaluation configurations. For example, configure evaluation selection 1014 can allow a user to traverse to the example user interfaces described, for example, in reference to user interfaces 900A-900C of FIGS. 9A-9C.

Example user interfaces 1000A and 1000B can include an evaluation dashboard selection 1012. The evaluation dashboard selection 1012 can allow the user to configure additional elements of user interfaces 1000A and 1000B such as configurations of the information displayed in metric display 1004a, metric display 1004b, graphic display 1010a, graphic display 1010b, and/or the like. For example, the evaluation dashboard selection 1012 can allow a user to change the metrics displayed, the form of graphic representations, and/or the like.

### V. Additional Example Implementations and Details

In an implementation the system (e.g., one or more aspects of the system 120, one or more aspects of the computing environment 100, and/or the like) may comprise, or be implemented in, a "virtual computing environment". As used herein, the term "virtual computing environment" should be construed broadly to include, for example, computer-readable program instructions executed by one or more processors (e.g., as described in the example of FIG. 11) to implement one or more aspects of the modules and/or functionality described herein. Further, in this implementation, one or more services/modules/engines and/or the like of the system may be understood as comprising one or more rules engines of the virtual computing environment that, in response to inputs received by the virtual computing environment, execute rules and/or other program instructions to modify operation of the virtual computing environment. For example, a request received from a user computing device may be understood as modifying operation of the virtual computing environment to cause the request access to a resource from the system. Such functionality may comprise a modification of the operation of the virtual computing environment in response to inputs and according to various rules. Other functionality implemented by the virtual computing environment (as described throughout this disclosure) may further comprise modifications of the operation of the virtual computing environment, for example, the operation of the virtual computing environment may change depending on the information gathered by the system. Initial operation of the virtual computing environment may be understood as an establishment of the virtual computing environment. In some implementations the virtual computing environment may comprise one or more virtual machines, containers, and/or other types of emulations of computing systems or environments. In some implementations the virtual computing environment may comprise a hosted computing environment that includes a collection of physical computing resources that may be remotely accessible and may be rapidly provisioned as needed (commonly referred to as "cloud" computing environment).

Implementing one or more aspects of the system as a virtual computing environment may advantageously enable executing different aspects or modules of the system on different computing devices or processors, which may increase the scalability of the system. Implementing one or more aspects of the system as a virtual computing environment may further advantageously enable sandboxing various aspects, data, or services/modules of the system from one another, which may increase security of the system by preventing, e.g., malicious intrusion into the system from spreading. Implementing one or more aspects of the system as a virtual computing environment may further advantageously enable parallel execution of various aspects or modules of the system, which may increase the scalability of the system. Implementing one or more aspects of the system as a virtual computing environment may further advantageously enable rapid provisioning (or de-provisioning) of computing resources to the system, which may increase scalability of the system by, e.g., expanding computing resources available to the system or duplicating operation of the system on multiple computing resources. For example, the system may be used by thousands, hundreds of thousands, or even millions of users simultaneously, and many megabytes, gigabytes, or terabytes (or more) of data may be transferred or processed by the system, and scalability of the system may enable such operation in an efficient and/or uninterrupted manner.

Various implementations of the present disclosure may be a system, a method, and/or a computer program product at any possible technical detail level of integration. The computer program product may include a computer-readable storage medium (or mediums) having computer-readable program instructions thereon for causing a processor to carry out aspects of the present disclosure.

For example, the functionality described herein may be performed as software instructions are executed by, and/or in response to software instructions being executed by, one or more hardware processors and/or any other suitable computing devices. The software instructions and/or other executable code may be read from a computer-readable storage medium (or mediums). Computer-readable storage mediums may also be referred to herein as computer-readable storage or computer-readable storage devices.

The computer-readable storage medium can be a tangible device that can retain and store data and/or instructions for use by an instruction execution device. The computer-readable storage medium may be, for example, but is not limited to, an electronic storage device (including any volatile and/or non-volatile electronic storage devices), a magnetic storage device, an optical storage device, an electromagnetic storage device, a semiconductor storage device, or any suitable combination of the foregoing. A non-exhaustive list of more specific examples of the computer-readable storage medium includes the following: a portable computer diskette, a hard disk, a solid state drive, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon, and any suitable combination of the foregoing. A computer-readable storage medium, as used herein, is not to be construed as being transitory signals per se, such as radio waves or other freely propagating electromagnetic waves, electromagnetic waves propagating through a waveguide or other transmission media (e.g., light pulses passing through a fiber-optic cable), or electrical signals transmitted through a wire.

Computer-readable program instructions described herein can be downloaded to respective computing/processing devices from a computer-readable storage medium or to an external computer or external storage device via a network, for example, the Internet, a local area network, a wide area network and/or a wireless network. The network may comprise copper transmission cables, optical transmission fibers, wireless transmission, routers, firewalls, switches, gateway computers, and/or edge servers. A network adapter card or network interface in each computing/processing device receives computer-readable program instructions from the network and forwards the computer-readable program instructions for storage in a computer-readable storage medium within the respective computing/processing device.

Computer-readable program instructions (as also referred to herein as, for example, "code," "instructions," "module," "application," "software application," "service," and/or the like) for carrying out operations of the present disclosure may be assembler instructions, instruction-set-architecture (ISA) instructions, machine instructions, machine dependent instructions, microcode, firmware instructions, state-setting data, configuration data for integrated circuitry, or either source code or object code written in any combination of one or more programming languages, including an object oriented programming language such as Smalltalk, C++, or the like, and procedural programming languages, such as the "C" programming language or similar programming languages. Computer-readable program instructions may be callable from other instructions or from itself, and/or may be invoked in response to detected events or interrupts. Computer-readable program instructions configured for execution on computing devices may be provided on a computer-readable storage medium, and/or as a digital download (and may be originally stored in a compressed or installable format that requires installation, decompression, or decryption prior to execution) that may then be stored on a computer-readable storage medium. Such computer-readable program instructions may be stored, partially or fully, on a memory device (e.g., a computer-readable storage medium) of the executing computing device, for execution by the computing device. The computer-readable program instructions may execute entirely on a user's computer (e.g., the executing computing device), partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider). In some implementations, electronic circuitry including, for example, programmable logic circuitry, field-programmable gate arrays (FPGA), or programmable logic arrays (PLA) may execute the computer-readable program instructions by utilizing state information of the computer-readable program instructions to personalize the electronic circuitry, in order to perform aspects of the present disclosure.

Aspects of the present disclosure are described herein with reference to flowchart illustrations and/or block diagrams of methods, apparatus (systems), and computer program products according to implementations of the disclosure. It will be understood that each block of the flowchart illustrations and/or block diagrams, and combinations of blocks in the flowchart illustrations and/or block diagrams, can be implemented by computer-readable program instructions.

These computer-readable program instructions may be provided to a processor of a general-purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks. These computer-readable program instructions may also be stored in a computer-readable storage medium that can direct a computer, a programmable data processing apparatus, and/or other devices to function in a particular manner, such that the computer-readable storage medium having instructions stored therein comprises an article of manufacture including instructions which implement aspects of the function/act specified in the flowchart(s) and/or block diagram(s) block or blocks.

The computer-readable program instructions may also be loaded onto a computer, other programmable data processing apparatus, or other device to cause a series of operational steps to be performed on the computer, other programmable apparatus or other device to produce a computer implemented process, such that the instructions which execute on the computer, other programmable apparatus, or other device implement the functions/acts specified in the flowchart and/or block diagram block or blocks. For example, the instructions may initially be carried on a magnetic disk or solid-state drive of a remote computer. The remote computer may load the instructions and/or modules into its dynamic memory and send the instructions over a telephone, cable, or optical line using a modem. A modem local to a server computing system may receive the data on the telephone/cable/optical line and use a converter device including the appropriate circuitry to place the data on a bus. The bus may carry the data to a memory, from which a processor may retrieve and execute the instructions. The instructions received by the memory may optionally be stored on a storage device (e.g., a solid-state drive) either before or after execution by the computer processor.

The flowcharts and block diagrams in the Figures illustrate the architecture, functionality, and operation of possible implementations of systems, methods, and computer program products according to various implementations of the present disclosure. In this regard, each block in the flowchart or block diagrams may represent a service, module, segment, or portion of instructions, which comprises one or more executable instructions for implementing the specified logical function(s). In some alternative implementations, the functions noted in the blocks may occur out of the order noted in the Figures. For example, two blocks shown in succession may, in fact, be executed substantially concurrently, or the blocks may sometimes be executed in the reverse order, depending upon the functionality involved. In addition, certain blocks may be omitted or optional in some implementations. The methods and processes described herein are also not limited to any particular sequence, and the blocks or states relating thereto can be performed in other sequences that are appropriate.

It will also be noted that each block of the block diagrams and/or flowchart illustration, and combinations of blocks in the block diagrams and/or flowchart illustration, can be implemented by special purpose hardware-based systems that perform the specified functions or acts or carry out combinations of special purpose hardware and computer instructions. For example, any of the processes, methods, algorithms, elements, blocks, applications, or other functionality (or portions of functionality) described in the preceding sections may be embodied in, and/or fully or partially automated via, electronic hardware such application-specific processors (e.g., application-specific integrated circuits (ASICs)), programmable processors (e.g., field programmable gate arrays (FPGAs)), application-specific circuitry, and/or the like (any of which may also combine custom hard-wired logic, logic circuits, ASICs, FPGAs, and/or the like with custom programming/execution of software instructions to accomplish the techniques).

Any of the above-mentioned processors, and/or devices incorporating any of the above-mentioned processors, may be referred to herein as, for example, "computers," "computer devices," "computing devices," "hardware computing devices," "hardware processors," "processing units," and/or the like. Computing devices of the above implementations may generally (but not necessarily) be controlled and/or coordinated by operating system software, such as Mac OS, iOS, Android, Chrome OS, Windows OS (e.g., Windows XP, Windows Vista, Windows 7, Windows 8, Windows 10, Windows 11, Windows Server, and/or the like), Windows CE, Unix, Linux, SunOS, Solaris, Blackberry OS, VxWorks, or other suitable operating systems. In other implementations, the computing devices may be controlled by a proprietary operating system. Conventional operating systems control and schedule computer processes for execution, perform memory management, provide file system, networking, I/O services, and provide a user interface functionality, such as a graphical user interface ("GUI"), among other things.

For example, Figure 11 shows a block diagram that illustrates a computer system 1100 upon which various implementations and/or aspects (e.g., one or more aspects of the operating environment 100, one or more aspects of the model management system 120, one or more aspects of the user device(s) 130, one or more aspects of the external system(s) 140, one or more aspects of the requestor device(s) 150, and/or the like) may be implemented. Multiple such computer systems 1100 may be used in various implementations of the present disclosure. Computer system 1100 includes a bus 1102 or other communication mechanism for communicating information, and a hardware processor, or multiple processors, 1104 coupled with bus 1102 for processing information. Hardware processor(s) 1104 may be, for example, one or more general purpose microprocessors.

Computer system 1100 also includes a main memory 1106, such as a random-access memory (RAM), cache and/or other dynamic storage devices, coupled to bus 1102 for storing information and instructions to be executed by processor 1104. Main memory 1106 also may be used for storing temporary variables or other intermediate information during execution of instructions to be executed by processor 1104. Such instructions, when stored in storage media accessible to processor 1104, render computer system 1100 into a special-purpose machine that is customized to perform the operations specified in the instructions. The main memory 1106 may, for example, include instructions to implement server instances, queuing modules, memory queues, storage queues, user interfaces, and/or other aspects of functionality of the present disclosure, according to various implementations.

Computer system 1100 further includes a read only memory (ROM) 1108 or other static storage device coupled to bus 1102 for storing static information and instructions for processor 1104. A storage device 1110, such as a magnetic disk, optical disk, or USB thumb drive (Flash drive), and/or the like, is provided and coupled to bus 1102 for storing information and instructions.

Computer system 1100 may be coupled via bus 1102 to a display 1112, such as a cathode ray tube (CRT) or LCD display (or touch screen), for displaying information to a computer user. An input device 1114, including alphanumeric and other keys, is coupled to bus 1102 for communicating information and command selections to processor 1104. Another type of user input device is cursor control 1116, such as a mouse, a trackball, or cursor direction keys for communicating direction information and command selections to processor 1104 and for controlling cursor movement on display 1112. This input device typically has two degrees of freedom in two axes, a first axis (e.g., x) and a second axis (e.g., y), that allows the device to specify positions in a plane. In some implementations, the same direction information and command selections as cursor control may be implemented via receiving touches on a touch screen without a cursor.

Computing system 1100 may include a user interface module to implement a GUI that may be stored in a mass storage device as computer executable program instructions that are executed by the computing device(s). Computer system 1100 may further, as described below, implement the techniques described herein using customized hard-wired logic, one or more ASICs or FPGAs, firmware and/or program logic which in combination with the computer system causes or programs computer system 1100 to be a special-purpose machine. According to one implementation, the techniques herein are performed by computer system 1100 in response to processor(s) 1104 executing one or more sequences of one or more computer-readable program instructions contained in main memory 1106. Such instructions may be read into main memory 1106 from another storage medium, such as storage device 1110. Execution of the sequences of instructions contained in main memory 1106 causes processor(s) 1104 to perform the process steps described herein. In alternative implementations, hard-wired circuitry may be used in place of or in combination with software instructions.

Various forms of computer-readable storage media may be involved in carrying one or more sequences of one or more computer-readable program instructions to processor 1104 for execution. For example, the instructions may initially be carried on a magnetic disk or solid-state drive of a remote computer. The remote computer can load the instructions into its dynamic memory and send the instructions over a telephone line using a modem. A modem local to computer system 1100 can receive the data on the telephone line and use an infra-red transmitter to convert the data to an infra-red signal. An infra-red detector can receive the data carried in the infra-red signal and appropriate circuitry can place the data on bus 1102. Bus 1102 carries the data to main memory 1106, from which processor 1104 retrieves and executes the instructions. The instructions received by main memory 1106 may optionally be stored on storage device 1110 either before or after execution by processor 1104.

Computer system 1100 also includes a communication interface 1118 coupled to bus 1102. Communication interface 1118 provides a two-way data communication coupling to a network link 1120 that is connected to a local network 1122. For example, communication interface 1118 may be an integrated services digital network (ISDN) card, cable modem, satellite modem, or a modem to provide a data communication connection to a corresponding type of telephone line. As another example, communication interface 1118 may be a local area network (LAN) card to provide a data communication connection to a compatible LAN (or WAN component to communicated with a WAN). Wireless links may also be implemented. In any such implementation, communication interface 1118 sends and receives electrical, electromagnetic, or optical signals that carry digital data streams representing various types of information.

Network link 1120 typically provides data communication through one or more networks to other data devices. For example, network link 1120 may provide a connection through local network 1122 to a host computer 1124 or to data equipment operated by an Internet Service Provider (ISP) 1126. ISP 1126 in turn provides data communication services through the worldwide packet data communication network now commonly referred to as the "Internet" 1128. Local network 1122 and Internet 1128 both use electrical, electromagnetic, or optical signals that carry digital data streams. The signals through the various networks and the signals on network link 1120 and through communication interface 1118, which carry the digital data to and from computer system 1100, are example forms of transmission media.

Computer system 1100 can send messages and receive data, including program code, through the network(s), network link 1120 and communication interface 1118. In the Internet example, a server 1130 might transmit a requested code for an application program through Internet 1128, ISP 1126, local network 1122 and communication interface 1118.

The received code may be executed by processor 1104 as it is received, and/or stored in storage device 1110, or other non-volatile storage for later execution.

As described above, in various implementations certain functionality may be accessible by a user through a web-based viewer (such as a web browser), or other suitable software program). In such implementations, the user interface may be generated by a server computing system and transmitted to a web browser of the user (e.g., running on the user's computing system). Alternatively, data (e.g., user interface data) necessary for generating the user interface may be provided by the server computing system to the browser, where the user interface may be generated (e.g., the user interface data may be executed by a browser accessing a web service and may be configured to render the user interfaces based on the user interface data). The user may then interact with the user interface through the web-browser. User interfaces of certain implementations may be accessible through one or more dedicated software applications. In certain implementations, one or more of the computing devices and/or systems of the disclosure may include mobile computing devices, and user interfaces may be accessible through such mobile computing devices (for example, smartphones and/or tablets).

Many variations and modifications may be made to the above-described implementations, the elements of which are to be understood as being among other acceptable examples. All such modifications and variations are intended to be included herein within the scope of this disclosure. The foregoing description details certain implementations. It will be appreciated, however, that no matter how detailed the foregoing appears in text, the systems and methods can be practiced in many ways. As is also stated above, it should be noted that the use of particular terminology when describing certain features or aspects of the systems and methods should not be taken to imply that the terminology is being re-defined herein to be restricted to including any specific characteristics of the features or aspects of the systems and methods with which that terminology is associated.

Conditional language, such as, among others, "can," "could," "might," or "may," unless specifically stated otherwise, or otherwise understood within the context as used, is generally intended to convey that certain implementations include, while other implementations do not include, certain features, elements, and/or steps. Thus, such conditional language is not generally intended to imply that features, elements and/or steps are in any way required for one or more implementations or that one or more implementations necessarily include logic for deciding, with or without user input or prompting, whether these features, elements and/or steps are included or are to be performed in any particular implementation.

The term "substantially" when used in conjunction with the term "realtime" forms a phrase that will be readily understood by a person of ordinary skill in the art. For example, it is readily understood that such language will include speeds in which no or little delay or waiting is discernible, or where such delay is sufficiently short so as not to be disruptive, irritating, or otherwise vexing to a user.

Conjunctive language such as the phrase "at least one of X, Y, and Z," or "at least one of X, Y, or Z," unless specifically stated otherwise, is to be understood with the context as used in general to convey that an item, term, and/or the like may be either X, Y, or Z, or a combination thereof. For example, the term "or" is used in its inclusive sense (and not in its exclusive sense) so that when used, for example, to connect a list of elements, the term "or" means one, some, or all of the elements in the list. Thus, such conjunctive language is not generally intended to imply that certain implementations require at least one of X, at least one of Y, and at least one of Z to each be present.

The term "a" as used herein should be given an inclusive rather than exclusive interpretation. For example, unless specifically noted, the term "a" should not be understood to mean "exactly one" or "one and only one"; instead, the term "a" means "one or more" or "at least one," whether used in the claims or elsewhere in the specification and regardless of uses of quantifiers such as "at least one," "one or more," or "a plurality" elsewhere in the claims or specification.

The term "comprising" as used herein should be given an inclusive rather than exclusive interpretation. For example, a general-purpose computer comprising one or more processors should not be interpreted as excluding other computer components, and may possibly include such components as memory, input/output devices, and/or network interfaces, among others.

While the above detailed description has shown, described, and pointed out novel features as applied to various implementations, it may be understood that various omissions, substitutions, and changes in the form and details of the devices or processes illustrated may be made without departing from the spirit of the disclosure. As may be recognized, certain implementations of the inventions described herein may be embodied within a form that does not provide all of the features and benefits set forth herein, as some features may be used or practiced separately from others. The scope of certain inventions disclosed herein is indicated by the appended claims rather than by the foregoing description. All changes which come within the meaning and range of equivalency of the claims are to be embraced within their scope.

### VI. Example Clauses

Examples of implementations of the present disclosure can be described in view of the following example clauses. The features recited in the below example implementations can be combined with additional features disclosed herein. Furthermore, additional inventive combinations of features are disclosed herein, which are not specifically recited in the below example implementations, and which do not include the same features as the specific implementations below. For sake of brevity, the below example implementations do not identify every inventive aspect of this disclosure. The below example implementations are not intended to identify key features or essential features of any subject matter described herein. Any of the example clauses below, or any features of the example clauses, can be combined with any one or more other example clauses, or features of the example clauses or other features of the present disclosure.

Clause 1. A computer-implemented method for managing one or more models, the computer-implemented method comprising, by one or more hardware processors executing program instructions: receiving, from a user and via one or more graphical user interfaces, one or more user inputs including at least: a first user input requesting to add an evaluation configuration to a defined modeling objective, wherein the defined modeling objective is associated with one or more models; a second user input specifying at least a first evaluation data set for the evaluation configuration; a third user input specifying at least a first evaluation library for the evaluation configuration, wherein the first evaluation library defines at least a first one or more evaluation metrics; and a fourth user input specifying at least a first subset definition for the evaluation configuration, wherein the first subset definition identifies a first plurality of subsets of the first evaluation data set; in response to the one or more user inputs: creating, storing, and/or updating the evaluation configuration including at least indications of the first evaluation data set, the first evaluation library, and the first subset definition; and associating the evaluation configuration with the defined modeling objective; and evaluating, based on the evaluation configuration, the one or more models associated with the defined modeling objective.

Clause 2. The computer-implemented method of Clause 1, wherein the evaluating comprises at least: executing each of the one or more models associated with the defined modeling objective on the first evaluation data set; determining, for each of the one or more models, and based on the first evaluation library and outputs of each of the one or more models, overall values of the first one or more evaluation metrics; and determining, for each of the first plurality of subsets of the first evaluation data set, and based on the first evaluation library and outputs of each of the one or more models, subset values of the first one or more evaluation metrics.

Clause 3. The computer-implemented method of Clause 2, wherein the first evaluation data set includes first expected values, and wherein the overall values of the first one or more evaluation metrics and the subset values of the first one or more evaluation metrics are determined based, at least in part, on the first expected values.

Clause 4. The computer-implemented method of Clause 3, wherein: specifying the first evaluation library includes at least: identifying a first data field of the first expected values; and identifying or defining a second data field for model output values.

Clause 5. The computer-implemented method of any of Clauses 2-4 further comprising, by the one or more hardware processors executing program instructions: causing display, via one or more graphical user interfaces, of results of the evaluating, wherein the results include at least, for each of the one or more models: the overall values of the first one or more evaluation metrics; and for each of the first plurality of subsets, the subset values of the first one or more evaluation metrics.

Clause 6. The computer-implemented method of any of Clauses 1-5, wherein the one or more models associated with the defined modeling objective comprises a plurality of models, and wherein the evaluating is performed for each of the plurality of models.

Clause 7. The computer-implemented method of any of Clauses 1-6, wherein: the one or more user inputs further include: a fifth user input specifying that newly submitted or updated models associated with the defined modeling objective are to be automatically evaluated upon submission of a new model or update of a models; and the computer-implemented method further comprises, by the one or more hardware processors executing program instructions: in response to association of a new model with the defined modeling objective and/or updating of a model of the one or more models associated with the defined modeling objective, automatically evaluating, based on the evaluation configuration, the new model and/or the model.

Clause 8. The computer-implemented method of any of Clauses 1-7, wherein the computer-implemented method further comprises, by the one or more hardware processors executing program instructions: causing display, via the one or more graphical user interfaces, of a listing of one or more selectable evaluation libraries, wherein specifying the first evaluation library includes at least: receiving user input selection of the first evaluation library from the of the one or more selectable evaluation libraries.

Clause 9. The computer-implemented method of Clause 8, wherein the computer-implemented method further comprises, by the one or more hardware processors executing program instructions: determining, based on one or more evaluation library definitions, the one or more selectable evaluation libraries.

Clause 10. The computer-implemented method of Clause 9, wherein the one or more evaluation library definitions each include at least: respective parsable descriptions of the evaluation libraries, respective identifications of user definable data fields, and respective specifications for determining related evaluation metrics.

Clause 11. The computer-implemented method of Clause 10, wherein the listing of the one or more selectable evaluation libraries includes respective evaluation library descriptions determined based on the respective parsable descriptions of the respective library definitions.

Clause 12. The computer-implemented method of any of Clauses 9-11, wherein the one or more evaluation library definitions are user definable as computer-readable code.

Clause 13. The computer-implemented method of any of Clauses 8-12, wherein the listing of the one or more selectable evaluation libraries includes core evaluation libraries and user-defined evaluation libraries.

Clause 14. The computer-implemented method of any of Clauses 8-13, wherein the listing of the one or more selectable evaluation libraries is searchable.

Clause 15. The computer-implemented method of any of Clauses 8-14, wherein the listing of the one or more selectable evaluation libraries is determined based on permissions associated with the user.

Clause 16. The computer-implemented method of any of Clauses 1-15, wherein: specifying the first subset definition includes at least: identifying at least a first data field for subsetting; and identifying, for the first data field, at least one of: data buckets, data ranges, or a number of data buckets or ranges; and the computer-implemented method further comprises, by the one or more hardware processors executing program instructions: causing display, via the one or more graphical user interfaces, of one or more visualizations of the first evaluation data set based at least in part on the first data field for subsetting.

Clause 17. The computer-implemented method of Clause 16, wherein specifying the first subset definition further includes at least: identifying at least a second data field for subsetting; and identifying, for the second data field, at least one of: data buckets, data ranges, or a number of data buckets or ranges.

Clause 18. The computer-implemented method of any of Clauses 1-17, wherein at least one of: the second user input includes specifying a second evaluation data set; the third user input includes specifying a second evaluation library, wherein the second evaluation library defines at least a second one or more evaluation metrics; or the fourth user input includes specifying a second subset definition, wherein the second subset definition identifies a second plurality of subsets of the first evaluation data set and second evaluation data set, if specified.

Clause 19. The computer-implemented method of Clause 18, wherein the evaluating comprises at least: executing each of the one or more models associated with the defined modeling objective on the first evaluation data set and the second evaluation data set, if specified; determining, for each of the one or more models, and based on the first evaluation library and outputs of each of the one or more models, overall values of the first one or more evaluation metrics and the second one or more evaluation metrics, if specified; and determining, for each of the subsets of each of the evaluation data sets, and based on the first evaluation library and outputs of each of the one or more models, subset values of the first one or more evaluation metrics and the second one or more evaluation metrics, if specified.

Clause 20. The computer-implemented method of Clause 19, wherein the computer-implemented method further comprises, by the one or more hardware processors executing program instructions: causing display, via one or more graphical user interfaces, of results of the evaluating, wherein the results include at least, for each of the one or more models: the overall values of the first one or more evaluation metrics and the second one or more evaluation metrics, if specified; and for each of the subsets of each of the evaluation data sets, the subset values of the first one or more evaluation metrics and the second one or more evaluation metrics, if specified.

Clause 21. The computer-implemented method of any of Clauses 1-20, wherein the computer-implemented method further comprises, by the one or more hardware processors executing program instructions: communicating, to a large language model ("LLM"), one or more items of information associated with the defined modeling objective; receiving, from the LLM, an output indicative of at least one of: the defined modeling objective, identify additional models that may be related to the defined modeling objective, the first evaluation data set, the first evaluation library, the first subset definitions, the one or more evaluation metrics, or an evaluation of evaluation metric values; and parsing the output and updating the one or more graphical user interfaces based on the output.

Clause 22. A system comprising: one or more computer-readable storage mediums having program instructions embodied therewith; and one or more processors configured to execute the program instructions to cause the system to perform the computer-implemented method of any of Clauses 1-21.

Clause 23. A computer program product comprising one or more computer-readable storage mediums having program instructions embodied therewith, the program instructions executable by one or more processors to cause the one or more processors to perform the computer-implemented method of any of Clauses 1-21.

## Claims

1. A computer-implemented method for managing one or more models, the computer-implemented method comprising, by one or more hardware processors executing program instructions:
receiving, from a user and via one or more graphical user interfaces, a plurality of user inputs including at least:
a first user input requesting to add an evaluation configuration to a defined modeling objective, wherein the defined modeling objective is associated with one or more models;
a second user input specifying at least a first evaluation data set for the evaluation configuration;
a third user input specifying at least a first evaluation library for the evaluation configuration, wherein the first evaluation library defines at least a first one or more evaluation metrics; and
a fourth user input specifying at least a first subset definition for the evaluation configuration, wherein the first subset definition identifies a first plurality of subsets of the first evaluation data set;
in response to the plurality of user inputs:
creating, storing, and/or updating the evaluation configuration including at least indications of the first evaluation data set, the first evaluation library, and the first subset definition; and
associating the evaluation configuration with the defined modeling objective; and
evaluating, based on the evaluation configuration, the one or more models associated with the defined modeling objective.

2. The computer-implemented method of Claim 1, wherein the evaluating comprises at least:
executing each of the one or more models associated with the defined modeling objective on the first evaluation data set;
determining, for each of the one or more models, and based on the first evaluation library and outputs of each of the one or more models, overall values of the first one or more evaluation metrics; and
determining, for each of the first plurality of subsets of the first evaluation data set, and based on the first evaluation library and outputs of each of the one or more models, subset values of the first one or more evaluation metrics.

3. The computer-implemented method of Claim 2, wherein the first evaluation data set includes first expected values, wherein the overall values of the first one or more evaluation metrics and the subset values of the first one or more evaluation metrics are determined based, at least in part, on the first expected values, and wherein specifying the first evaluation library includes at least:
identifying a first data field of the first expected values; and
identifying or defining a second data field for model output values.

4. The computer-implemented method of any of Claims 2-3 further comprising, by the one or more hardware processors executing program instructions:
causing display, via one or more graphical user interfaces, of results of the evaluating, wherein the results include at least, for each of the one or more models:
the overall values of the first one or more evaluation metrics; and
for each of the first plurality of subsets, the subset values of the first one or more evaluation metrics.

5. The computer-implemented method of any of Claims 1-4, wherein the one or more models associated with the defined modeling objective comprises a plurality of models, and wherein the evaluating is performed for each of the plurality of models.

6. The computer-implemented method of any of Claims 1-5, wherein:
the plurality of user inputs further include:
a fifth user input specifying that newly submitted or updated models associated with the defined modeling objective are to be automatically evaluated upon submission of a new model or update of a models; and
the computer-implemented method further comprises, by the one or more hardware processors executing program instructions:
in response to association of a new model with the defined modeling objective and/or updating of a model of the one or more models associated with the defined modeling objective, automatically evaluating, based on the evaluation configuration, the new model and/or the model.

7. The computer-implemented method of any of Claims 1-6, wherein the computer-implemented method further comprises, by the one or more hardware processors executing program instructions:
causing display, via the one or more graphical user interfaces, of a listing of one or more selectable evaluation libraries,
wherein specifying the first evaluation library includes at least:
receiving user input selection of the first evaluation library from the of the one or more selectable evaluation libraries.

8. The computer-implemented method of Claim 7, wherein the computer-implemented method further comprises, by the one or more hardware processors executing program instructions:
determining, based on one or more evaluation library definitions, the one or more selectable evaluation libraries.

9. The computer-implemented method of Claim 8, wherein the one or more evaluation library definitions each include at least:
respective parsable descriptions of the evaluation libraries,
respective identifications of user definable data fields, and
respective specifications for determining related evaluation metrics, and
wherein the listing of the one or more selectable evaluation libraries includes respective evaluation library descriptions determined based on the respective parsable descriptions of the respective library definitions.

10. The computer-implemented method of any of Claims 1-9, wherein:
specifying the first subset definition includes at least:
identifying at least a first data field for subsetting; and
identifying, for the first data field, at least one of: data buckets, data ranges, or a number of data buckets or ranges; and
the computer-implemented method further comprises, by the one or more hardware processors executing program instructions:
causing display, via the one or more graphical user interfaces, of one or more visualizations of the first evaluation data set based at least in part on the first data field for subsetting.

11. The computer-implemented method of any of Claims 1-10, wherein at least one of:
the second user input includes specifying a second evaluation data set;
the third user input includes specifying a second evaluation library, wherein the second evaluation library defines at least a second one or more evaluation metrics; or
the fourth user input includes specifying a second subset definition, wherein the second subset definition identifies a second plurality of subsets of the first evaluation data set and second evaluation data set, if specified, and
wherein the evaluating comprises at least:
executing each of the one or more models associated with the defined modeling objective on the first evaluation data set and the second evaluation data set, if specified;
determining, for each of the one or more models, and based on the first evaluation library and outputs of each of the one or more models, overall values of the first one or more evaluation metrics and the second one or more evaluation metrics, if specified; and
determining, for each of the subsets of each of the evaluation data sets, and based on the first evaluation library and outputs of each of the one or more models, subset values of the first one or more evaluation metrics and the second one or more evaluation metrics, if specified.

12. The computer-implemented method of Claim 11, wherein the computer-implemented method further comprises, by the one or more hardware processors executing program instructions:
causing display, via one or more graphical user interfaces, of results of the evaluating, wherein the results include at least, for each of the one or more models:
the overall values of the first one or more evaluation metrics and the second one or more evaluation metrics, if specified; and
for each of the subsets of each of the evaluation data sets, the subset values of the first one or more evaluation metrics and the second one or more evaluation metrics, if specified.

13. The computer-implemented method of any of Claims 1-12, wherein the computer-implemented method further comprises, by the one or more hardware processors executing program instructions:
communicating, to a large language model, LLM, one or more items of information associated with the defined modeling objective;
receiving, from the LLM, an output indicative of at least one of:
the defined modeling objective,
identify additional models that may be related to the defined modeling objective,
the first evaluation data set,
the first evaluation library,
the first subset definitions,
the one or more evaluation metrics, or
an evaluation of evaluation metric values; and
parsing the output and updating the one or more graphical user interfaces based on the output.

14. A system comprising:
one or more computer readable storage mediums having program instructions embodied therewith; and
one or more processors configured to execute the program instructions to cause the system to perform the computer-implemented method of any of Claims 1-13.

15. A computer program product comprising one or more computer-readable storage mediums having program instructions embodied therewith, the program instructions executable by one or more processors to cause the one or more processors to perform the computer-implemented method of any of Claims 1-13.
